# EUROPEAN PATENT APPLICATION

(11) **EP 4 654 786 A2**
(43) Date of publication of application: **26.11.2025**
(21) Application number: 25201992.2
(22) Date of filing: 12.09.2025
(51) Int. Cl.: H10F 10/19, H10F 19/40, H10K 30/57

(54) **TANDEM SOLAR CELL AND PHOTOVOLTAIC MODULE**

(30) Priority: 03.07.2025 CN 202510918785
(71) Applicant: Jinko Solar (Haining) Co., Ltd., Haining City, Zhejiang 314415 (CN)
(72) Inventor: YU, Yong, HAINING CITY, 314415 (CN); XU, Menglei, HAINING CITY, 314415 (CN); WANG, Jungan, HAINING CITY, 314415 (CN); YAN, Xunlei, HAINING CITY, 314415 (CN); ZHANG, Xinyu, HAINING CITY, 314415 (CN); YANG, Jie, HAINING CITY, 314415 (CN)
(74) Representative: Ipsilon

(57) **Abstract**

Disclosed is a tandem solar cell (100a to 100h), including a top cell unit (110a, 110b), a bottom cell unit (120a to 120c), and a recombination layer (130a, 130b). Orthographic projections of the top cell unit and the bottom cell unit on a reference plane (E) coincide with each other to form an overlapping projection (y2). The bottom cell unit includes a substrate (121) and a first passivation contact layer (122a to 122d). The first passivation contact layer includes a first tunneling layer (1221a) and a first doped conductive layer (1222a) stacked and disposed on a surface (m1) of the substrate (121) facing the top cell unit. An orthographic projection (y1) of the first passivation contact layer on the reference plane (E) is within a range of the overlapping projection, and an area of the orthographic projection is smaller than an area of the overlapping projection.

## Description

### TECHNICAL FIELD

The present invention relates to the technical field of solar cells, and in particular to tandem solar cells and photovoltaic modules.

### BACKGROUND

Since perovskite and perovskite crystalline silicon tandem solar cells have excellent photoelectric conversion efficiency, they have become one of the research hotspots in the technical field of solar cell. Therefore, how to further improve the photoelectric conversion efficiency of the cells has become the key to the technology development of this field.

### SUMMARY

Based on this, a tandem solar cell and a photovoltaic module are provided. The invention is set out in the appended set of claims.

In the above-mentioned tandem solar cell and photovoltaic module, the bottom cell unit of the tandem solar cell includes the substrate and the first passivation contact layer, and the first passivation contact layer includes the first tunneling layer and the first doped conductive layer. By configuring the area of the orthographic projection of the first passivation contact layer on the reference plane to be smaller than the area of the overlapping projection of the top cell unit and the bottom cell unit, the first passivation contact layer covers partial region of the surface of the substrate facing the top cell unit, so that: not only the optical parasitic absorption of the first doped conductive layer is reduced, and the optical loss of the cell is reduced, thereby increasing the short-circuit current of the cell, but also the physical contact area and electrical connection efficiency of the interfaces are increased, and the resistance between the interfaces is reduced, which is beneficial to the transport and collection of minority carriers in the cell, thereby increasing the fill factor of the cell. What's more, since the first passivation layer is arranged on the first sub-surface exposed by the first passivation contact layer and on the first target surface of the first passivation contact layer, the surfaces of the recombination layer and the first passivation layer facing each other are in contact with each other, thereby not only reducing the film defects of the first passivation contact layer, reducing the recombination centers, and improving the consistency and reliability of the first passivation contact layer, but also reducing the potential energy barrier between the film layers, which is beneficial to the transport and collection of the minority carriers in the cell, thereby improving the open-circuit voltage and the fill factor of the cell. Therefore, the efficiency of the cell can be improved through the mutual cooperation of the first passivation contact layer and the first passivation layer.

Additional aspects and advantages of the embodiments of the present invention will be described in part in the description below, and other part will become apparent from the description below or will be learned from the implements of the embodiments of the present invention.

### DESCRIPTION OF THE DRAWINGS

Various additional advantages and benefits will become apparent to those of ordinary skill in the art from reading the following detailed description of the embodiments. The drawings are only for the purpose of illustrating the embodiments but not to be considered as limitations on the present application. Moreover, throughout the drawings, the same reference numerals are used to denote the same parts. In the accompanying drawings:
FIG. 1 is a schematic sectional view of a tandem solar cell in some embodiments of the present invention;
FIG. 2 is a schematic sectional view showing a cooperation of a substrate, a first passivation contact layer, a first passivation layer, and a recombination layer in some embodiments of the present invention;
FIG. 3 is a schematic view showing a relationship between a first projection and a second projection in some embodiments of the present invention;
FIG. 4 is a schematic top view showing a cooperation of the substrate and the first passivation contact layer in other embodiments of the present invention;
FIG. 5 is a schematic top view showing a cooperation of the substrate and the first passivation contact layer in some other embodiments of the present invention;
FIG. 6 is a schematic top view showing a cooperation of the substrate and the first passivation contact layer in some other embodiments of the present invention;
FIG. 7 is a schematic sectional view of a tandem solar cell in some other embodiments of the present invention;
FIG. 8 is a schematic sectional view of the recombination layer in the tandem solar cell shown in FIG. 7;
FIG. 9 is a schematic sectional view of a tandem solar cell in some other embodiments of the present invention;
FIG. 10 is a schematic sectional view showing a cooperation of the recombination layer and the second passivation layer in the tandem solar cell shown in FIG. 9;
FIG. 11 is a schematic sectional view of a tandem solar cell in some other embodiments of the present invention;
FIG. 12 is a schematic sectional view of a partial structure of the tandem solar cell shown in FIG. 11;
FIG. 13 is a schematic top view showing a cooperation of the substrate and the second passivation contact structure in other embodiments of the present invention;
FIG. 14 is a schematic sectional view of a tandem solar cell in some other embodiments of the present invention;
FIG. 15 is a schematic sectional view of a partial structure of the tandem solar cell shown in FIG. 14;
FIG. 16 is a schematic top view showing a cooperation of the substrate and a doped layer in some other embodiments of the present invention;
FIG. 17 is a schematic sectional view of a tandem solar cell in some other embodiments of the present invention;
FIG. 18 is a schematic sectional view of a tandem solar cell in some other embodiments of the present invention;
FIG. 19 is a schematic sectional view of a tandem solar cell in some other embodiments of the present invention;
FIG. 20 is a schematic view showing a structure of a photovoltaic module in some embodiments of the present invention.

Description of reference numerals:
tandem solar cell 100a, 100b, 100c, 100d, 100e, 100f, 100g, 100h;
top cell unit 110a, 110b; first charge transport layer 111; light absorption layer 112; second charge transport layer 113; transparent electrode layer 114a, 114b; first sublayer 1141; second sublayer 1142; protective layer 115;
bottom cell unit 120a, 120b, 120c;
substrate 121; first surface m1; first sub-surface m11; second surface m2; second sub-surface m21; third sub-surface m22;
first passivation contact layer 122a, 122b, 122c, 122d; first tunneling layer 1221a; first doped conductive layer 1222a; first target surface t1; first passivation contact portion 1220a, 1220b; first through hole k1; first sub-portion 12201; second sub-portion 12202;
second passivation contact layer 123a, 123b, 123c; second tunneling layer 1231a, 1231b; second doped conductive layer 1232a, 1232b; second target surface t2; second passivation contact portion 1230; second through hole k2;
doped layer 124a, 124b; doped portion 1240; third through hole k3; third target surface t3;
recombination layer 130a, 130b; first portion 131; first thickness d1; second portion 132; second thickness d2; target portion 1321;
first passivation layer 140; first dimension h1;
second passivation layer 150; second dimension h2;
third passivation layer 160a, 160b; third dimension h3;
fourth passivation layer 170; fourth dimension h4;
first electrode 180;
second electrode 190;
first projection y1; second projection y2; reference plane E;
first direction F1; second direction F2; third direction F3; fourth direction F4; fifth direction F5;
photovoltaic module 10; cell string 11; encapsulation layer 12; cover plate 13; and conducting strip 14.

### DETAILED DESCRIPTION OF THE EMBODIMENTS

In order to make the above objectives, features and advantages of the present application clearer and to be better understood, specific implementations of the present application are described in detail below with reference to the accompanying drawings. In the following description, many specific details are set forth to make the present application to be fully understood. However, the present application can be implemented in many other ways different from those described herein, and those skilled in the art can make similar improvements without departing from the connotation of the present application. Therefore, the present application is not limited by the specific embodiments disclosed below.

In the description of the present application, it should be understood that if the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. appear, the orientation or position relationships indicated by these terms are based on the orientation or position relationships shown in the accompanying drawings and are merely intended to facilitate the description of the present application and simplify the description, rather than indicating or implying that the indicated device or element must have a particular orientation or be constructed and operated in a particular orientation, and therefore are not to be interpreted as limitation on the present application.

In addition, if the terms "first" and "second" appear, these terms are used for descriptive purposes only but cannot be interpreted as indicating or implying relative importance or implicitly specifying the number of indicated technical features. Thus, the features defined as "first" and "second" may explicitly or implicitly include at least one of these features. In the description of the present application, if the term "plurality" appears, the "plurality" means at least two, such as two, three, etc., unless otherwise clearly and specifically defined.

In the present application, unless otherwise clearly specified and limited, if the terms "mount", "connection", "communication", "fix", etc., appear, these terms should be understood in a broad sense, for example, may be a fixed connection or a detachable connection, or an integrated connection; or may be a mechanical connection or an electrical connection; or may be a direct connection or an indirect connection through an intermediate medium; or may be an internal communication between two elements or an interaction relationship between two elements, unless otherwise clearly defined. It is worth noting that, in the following description and the appended claims, one feature being electrically connected to another feature not only includes one feature being in direct contact with another feature to form an electric energy transmission or a current transmission channel, but also includes the case that there is an intermediate feature between the one feature and the other feature, and an electric energy transmission channel or a current transmission channel is formed by the feature, the other feature and the intermediate feature therebetween to achieve an electric energy transmission or delivery. Those of ordinary skill in the art can understand the specific meanings of the above terms in the present application according to specific situations.

In the present application, unless otherwise clearly specified and limited, if there is a description that a first feature is "above" or "under" a second feature, etc., or similar description, it may mean that the first and second features are in direct contact, or the first and second features are in indirect contact through an intermediate medium. Moreover, the first feature being "on top of", "above" and "over" the second feature may mean that the first feature is directly above or obliquely above the second feature, or simply means that the horizontal height of the first feature is greater than that of the second feature. The first feature being "under", "beneath" and "below" the second feature may mean that the first feature is directly below or obliquely below the second feature, or simply means that the horizontal height of the first feature is less than the second feature.

It should be noted that if an element or layer is referred to as being "on", "adjacent to", "connected to", "coupled to", "fixed to" or "disposed on" another element or layer, it may be directly on the other element or layer or there may also be an intermediate element or layer. If an element is considered to be "connected to" another element, it may be directly connected to the other element or there may be an intermediate element as well. It should be understood that although the terms first, second, third, etc. may be used to describe various elements, components, regions, layers, doping types and/or parts, these elements, components, regions, layers, doping types and/or parts should not be limited by these terms. These terms are only used to distinguish one element, component, region, layer, doping type or part from another element, component, region, layer, doping type or part. Therefore, without departing from the teachings of the present application, the first element, component, region, layer, doping type or part described below may be represented as a second element, component, region, layer or part. For example, the first doping type may be referred to as the second doping type, and similarly, the second doping type may be referred to as the first doping type. The first doping type and the second doping type are different doping types, for example, the first doping type may be P-type and the second doping type may be N-type, or the first doping type may be N-type and the second doping type may be P-type. If present, the terms "vertical", "horizontal", "upper", "lower", "left", "right" and similar expressions used in the present application are only for illustrative purposes but not intended to be the only implementation. It should be understood that in addition to the orientations shown in the figures, the spatial relationship terms also include different orientations of the device in use and operation. For example, if the device in a figure is flipped, the element or feature described as "below other elements" or "below" or "under" will be oriented as "above" or "over" other elements or features. Therefore, the exemplary terms "below" and "under" may include both upper and lower orientations. Furthermore, the devices may be oriented in other manner (e.g., by rotating 90 degrees or at other orientations) and the spatial descriptors used herein should be interpreted accordingly.

In addition, the embodiments of the present application are described with reference to sectional views as schematic views of ideal embodiments (and intermediate structures) of the present application, and variations in the shapes shown due to, for example, manufacturing techniques and/or tolerances are anticipated. Therefore, the embodiments of the present application should not be limited to the specific shapes of the regions shown herein, but include deviations in shapes due to, for example, manufacturing techniques, etc.

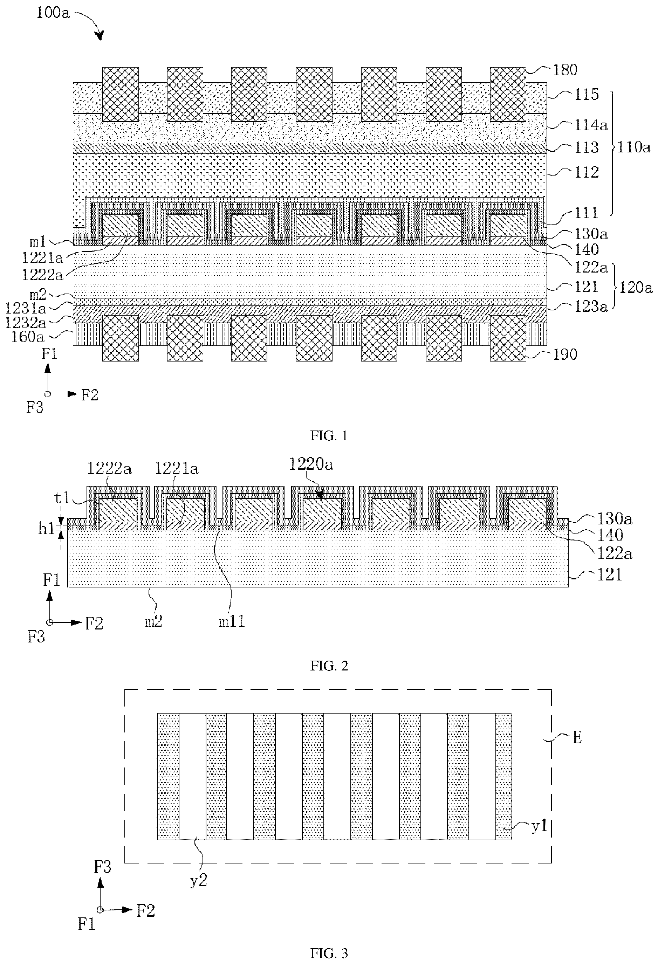

According to some embodiments of the present invention, referring to FIG. 1, FIG. 1 is a schematic sectional view of a tandem solar cell 100a in some embodiments of the present invention. An embodiment of the present invention provides a tandem solar cell 100a, including a top cell unit 110a and a bottom cell unit 120a stacked along a first direction F1, and a recombination layer 130a disposed between the top cell unit 110a and the bottom cell unit 120a. The bottom cell unit 120a includes a substrate 121 and a first passivation contact layer 122a, and the first passivation contact layer 122a includes a first tunneling layer 1221a and a first doped conductive layer 1222a stacked and disposed on a surface of the substrate 121 facing the top cell unit 110a.

The first direction F1 is a thickness direction of the tandem solar cell 100a. Exemplarily, the bottom cell unit 120a may be a Tunnel Oxide Passivated Contact (TOPCon) cell, and the top cell unit 110a may be a perovskite cell. The bottom cell unit 120a may be a single-sided TOPCon cell or a double-sided TOPCon cell, which is not limited herein. That is, a top cell unit 110a with a relatively wide bandgap may be deposited on the bottom cell unit 120a to form a tandem cell, which can make use of solar energy to the greatest extent, broaden a spectral response, and improve the efficiency of the solar cell device.

The recombination layer 130a can not only be configured to modify an interface between the bottom cell unit 120a and the top cell unit 110a, but also improve the passivation performance and interface contact performance of the bottom cell unit 120a affected by the manufacture of the top cell unit 110a. Specifically, electrons and holes in the top cell unit 110a can be recombined in the recombination layer 130a to maximize the consistency between the current of the bottom cell unit 120a and the current of the top cell unit 110a. In addition, the recombination layer 130a has a certain longitudinal conductivity, which is conducive to the charge transport. Exemplarily, a conductive oxide film may be used as the recombination layer 130a. For example, the material of the recombination layer 130a may be one of or a combination of at least two of Indium Tin Oxide (ITO), Tungsten-doped Indium Oxide (IWO), Cerium-doped indium oxide (ICO), indium zinc oxide (IZO), Al-doped zinc oxide (AZO), gallium zinc oxide (GZO), SnO₂, or TiO₂. The recombination layer 130a may be a single-layer structure or a multi-layer structure. The material of the single-layer structure may include one of or a combination of more of the aforementioned materials, and the multi-layer structure may be a stacked structure, such as an ITO layer and an IWO layer, which is not specifically limited herein.

Exemplarily, a thickness of the recombination layer 130a is in a range from 10 nm to 40 nm. For example, the thickness of the recombination layer 130a may be 10 nm, 15 nm, 20 nm, 26 nm, 30 nm, 35 nm or 40 nm, or may also be any other value within the range from 10 nm to 40 nm, which is not specifically limited herein.

The substrate 121 is configured to receive incident light and generate photogenerated carriers. The substrate 121 may be selected according to actual needs. Exemplarily, the substrate 121 may be a silicon substrate. The doping type of substrate 121 is not specifically limited. For example, the substrate 121 may be an N-type doped silicon substrate, or a P-type doped silicon substrate, which is not specifically limited. In an embodiment of the present invention, the substrate 121 may be an N-type single crystal silicon wafer. Exemplarily, a thickness of the substrate 121 is in a range from 120 µm to 240 µm. For example, the thickness of the substrate 121 may be 120 µm, 130 µm, 140 µm, 150 µm, 160 µm, 170 µm, 180 µm, 200 µm, 220 µm or 240 µm, or may also be any other value within the range from 120µm to 240µm, which is not specifically limited herein.

The substrate 121 has a first surface m1 and a second surface m2 which are arranged opposite to each other along the first direction F1. The first surface m1 is a light-receiving surface, and the second surface m2 is a backlight surface. The light-receiving surface and the backlight surface are relative. The light-receiving surface specifically refers to a surface of the substrate in the tandem solar cell 100a or in a photovoltaic module, where sunlight mainly irradiates. The light-receiving surface usually has a textured structure, which can increase the light absorption area, increase the photocurrent, and contribute to an improvement of the efficiency of the cell.

The first tunneling layer 1221a is configured to achieve an interface passivation of the first surface m1 of the substrate 121, and takes functions of chemical passivation. Specifically, by saturating dangling bonds in the first surface m1 of the substrate 121, the interface defect state density at the first surface m1 of the substrate 121 is reduced, thereby reducing the recombination centers in the first surface m1 of the substrate 121 to reduce the carrier recombination rate. The material of the tunneling oxide layer may be a dielectric material. For example, the material of the first tunneling layer 1221a can be at least one of silicon oxide, magnesium fluoride, amorphous silicon, polycrystalline silicon, silicon carbide, silicon nitride, silicon oxynitride, aluminum oxide or titanium oxide. In an embodiment of the present invention, the first tunneling layer 1221a may be formed by a low pressure chemical vapor deposition (LPCVD) process. The first tunneling layer 1221a may also be prepared by other processes such as a thermal oxidation process, a plasma oxidation process or a nitric acid oxidation process, which is not specifically limited herein.

Exemplarily, a dimension of the first tunneling layer 1221a along the first direction F1, namely the thickness of the first tunneling layer 1221a, may be in a range from 0.5 nm to 3 nm. For example, the thickness of the first tunneling layer 1221a may be 0.5 nm, 1 nm, 2 nm or 3 nm, or may also be any other value in the range from 0.5 nm to 3 nm, which is not specifically limited herein. By controlling the thickness of the first tunneling layer 1221a, it is possible to restrain the reduction of the fill factor caused by the contact resistance and to achieve a certain passivation effect.

The dopant of the first doped conductive layer 1222a is adapted to the conductivity type of the dopant of the substrate 121. For example, when the substrate 121 is an N-type substrate, the dopant of the substrate 121 may be phosphorus and/or antimony. The dopant of the first doped conductive layer 1222a is phosphorus. For another example, when the substrate 121 is a P-type substrate, the dopant of the first doped conductive layer 1222a is boron. In an embodiment of the present invention, the first doped conductive layer 1222a is formed by doping amorphous silicon, microcrystalline silicon, polycrystalline silicon, etc. with an N-type dopant. Exemplarily, the first doped conductive layer 1222a is a phosphorus-doped polycrystalline silicon layer. In this case, the stacked first tunneling layer 1221a and the first doped conductive layer 1222a together form a passivation contact structure, and the passivation contact structure provides good surface passivation for the first surface m1 of the substrate 121.

Exemplarily, the dimension of the first doped conductive layer 1222a along the first direction F1, namely the thickness of the first doped conductive layer 1222a, is in a range from 30 nm to 300 nm. For example, the thickness of the first doped conductive layer 1222a may be 30 nm, 40 nm, 50 nm, 60 nm, 70 nm, 80 nm, 100 nm, 150 nm, 200 nm, 230 nm, 280 nm or 300 nm, or may also be any other value within the range from 30 nm to 300 nm, which is not specifically limited herein.

Orthographic projections of the top cell unit 110a and the bottom cell unit 120a on a reference plane E coincide with each other to form an overlapping projection, and the reference plane E is a plane perpendicular to the first direction F1. The orthographic projection of the first passivation contact layer 122a on the reference plane E is located within the range of the overlapping projection, and the area of the orthographic projection of the first passivation contact layer 122a on the reference plane E is smaller than the area of the overlapping projection. A portion of the surface of the substrate 121 facing the top cell unit 110a, which is exposed by the first passivation contact layer 122a, is a first sub-surface m11. The first passivation contact layer 122a has a first target surface t1 that is not in contact with the surface of the substrate 121 facing the top cell unit 110a and located in the tandem solar cell 100a. The tandem solar cell 100a further includes a first passivation layer 140 disposed on the first sub-surface m11 and the first target surface t1. The surfaces of the recombination layer 130a and the first passivation layer 140 facing each other are in contact with each other.

FIG. 2 is a schematic sectional view showing a cooperation of the substrate 121, the first passivation contact layer 122a, the first passivation layer 140 and the recombination layer 130a in some embodiments of the present invention, and FIG. 3 is a schematic view showing a relationship between a first projection y1 and a second projection y2 in some embodiments of the present invention. Referring to FIG. 2 and FIG. 3, an orthographic projection of the first passivation contact layer 122a on the reference plane E is the first projection y1, and the overlapping projection is the second projection y2. The first projection y1 is located within the range of the second projection y2, and the area of the first projection y1 is smaller than the area of the second projection y2. As shown in FIG. 2 and FIG. 3, the second direction F2 and the third direction F3 are length and width directions of the tandem solar cell 100a, respectively. The first direction F1, the second direction F2 and the third direction F3 are perpendicular to each other, and the second direction F2 and the third direction F3 are parallel to the reference plane E.

Since the area of the first projection y1 is smaller than the area of the second projection y2, the first passivation contact layer 122a does not completely cover the surface of the substrate 121 facing the top cell unit 110a, that is, the first passivation contact layer 122a does not completely cover the first surface m1 of the substrate 121. The portion of the first surface m1, which is not covered by the first passivation contact layer 122a, is the first sub-surface m11. Surfaces of the first passivation contact layer 122a include a surface (which is referred to as the bottom surface) in contact with the substrate 121, a surface (which is referred to as the top surface) facing away from the substrate 121, and surfaces (which are referred to as side surfaces) connecting the surface in contact with the substrate 121 and the surface facing away from the substrate 121, respectively. According to the structure of the first passivation contact layer 122a, the side surfaces of the first passivation contact layer 122a may be entirely located in the tandem solar cell 100a. Alternatively, a part of the side surfaces of the first passivation contact layer 122a may be located in the tandem solar cell 100a, and the other part of the side surfaces of the first passivation contact layer 122a may not be located in the tandem solar cell 100a. Exemplarily, FIG. 1 and FIG. 2 illustrate the case where the side surfaces of the first passivation contact layer 122a are entirely located in the tandem solar cell 100a. In the case where the other part of the side surfaces of the first passivation contact layer 122a is not located in the tandem solar cell 100a, the other part of the side surfaces may be flush with the side surfaces of the tandem solar cell 100a. That is, the first target surface t1 includes the aforementioned top surface of the first passivation contact layer 122a and the side surfaces of the first passivation contact layer 122a located in the tandem solar cell.

Exemplarily, taking an N-type substrate as an example, an initial first tunneling layer is formed on the first surface m1 of the substrate 121 by an LPCVD process. Specifically, oxygen may be introduced under heating conditions, and silicon on the first surface m1 of the substrate 121 reacts with oxygen to generate silicon oxide, thereby forming the initial first tunneling layer. Alternatively, the initial first tunneling layer may also be manufactured by other processes such as a thermal oxidation process, a plasma oxidation process or a nitric acid oxidation process, which are not specifically limited herein. Subsequently, phosphorus diffusion and oxidation annealing may be performed on the amorphous silicon layer on the first surface m1 of the substrate 121 in a high-temperature diffusion furnace to form an N-type polycrystalline silicon layer, that is, an initial first doped conductive layer. The initial first doped conductive layer and the initial first tunneling layer constitute an initial first passivation contact layer. Then, partial structure of the initial first passivation contact layer is removed by a laser etching process to form the first passivation contact layer 122a. Alternatively, the first passivation contact layer 122a may also be formed by arranging a mask, which is not specifically limited herein.

During manufacture of the first passivation contact layer 122a, there are risks of generating thermal damage, mechanical stress damage, plasma damage, etc. when the laser etching process is carried out, and there are risks of generating etching damage, thermal stress damage, etc. when the mask process is carried out, thus causing the risk of damaging the first passivation contact layer 122a. Further, whether it is etching ion bombardment or laser thermal stress, it will eventually cause the silicon atoms on the surface of the first passivation contact layer 122a to lose nearest-neighbor bonding, resulting in the formation of dangling bonds. Dangling bonds may be generated on the undamaged portion of the surface of the first passivation contact layer 122a for the reason that silicon atoms at the grain boundary cannot completely form tetrahedral bonding due to different grain orientations, or dangling bonds may be generated for the reason that a local bond distortion is caused by the difference in covalent radius between doping atoms and the silicon atoms. Therefore, whether they are the dangling bonds at the damaged portion or the dangling bonds at the undamaged portion, they can capture electrons or holes to form fixed charges or trapped charges, thus resulting in drifts of device parameters. Moreover, the dangling bonds at the damaged and undamaged portions on the surface of the first passivation contact layer 122a have small difference in chemical activities and have similar electronic structures. Therefore, by arranging the first passivation layer 140 and controlling the hydrogen content or charge density in the first passivation layer 140, the damaged and undamaged portions on the surface of the first passivation contact layer 122a can be both passivated. In addition, stresses may be generated at the boundary of the damaged and undamaged portions of the first passivation contact layer 122a due to a difference in thermal expansion coefficients. Therefore, by arranging the first passivation layer 140, not only the defects can be controlled more uniformly, but also the stresses at the boundary of the damaged and undamaged portions can be improved, thereby improving the consistency and reliability of the first passivation contact layer 122a.

In the embodiment of the present invention, by configuring the area of the orthographic projection of the first passivation contact layer 122a on the reference plane E to be smaller than the area of the overlapping projection of the top cell unit 110a and the bottom cell unit 120a, the first passivation contact layer 122a covers partial region of the surface of the substrate 121 facing the top cell unit 110a, so that: not only the optical parasitic absorption of the first doped conductive layer 1222a is reduced, and the optical loss of the cell is reduced, thereby increasing the short-circuit current of the cell, but also the physical contact area and electrical connection efficiency of the interfaces are increased, and the resistance between the interfaces is reduced, which is beneficial to the transport and collection of minority carriers in the cell, thereby increasing the fill factor of the cell. What's more, since the first passivation layer 140 is arranged on the first sub-surface m11 exposed by the first passivation contact layer 122a and on the first target surface t1 of the first passivation contact layer 122a, the surfaces of the recombination layer 130a and the first passivation layer 140 facing each other are in contact with each other, thereby not only reducing the film defects of the first passivation contact layer 122a, reducing the recombination centers, and improving the consistency and reliability of the first passivation contact layer 122a, but also reducing the potential energy barrier between the film layers, which is beneficial to the transport and collection of the minority carriers in the cell, thereby improving the open-circuit voltage and the fill factor of the cell. Therefore, the efficiency of the cell can be improved through the mutual cooperation of the first passivation contact layer 122a and the first passivation layer 140.

According to some embodiments of the present invention, continuing to refer to FIGS. 1 to 3, the first passivation contact layer 122a includes a plurality of first passivation contact portions 1220a arranged at intervals. That is, all first passivation contact portions 1220a are spaced apart, all first passivation contact portions 1220a are separately arranged, and all first passivation contact portions 1220a define intervals.

Due to the absence of the first passivation contact portions 1220a in the intervals, optical parasitic absorption of the first doped conductive layers 1222a can be further reduced.

According to some embodiments of the present invention, continuing to refer to FIGS. 1 to 3, at least part of the first passivation contact portions 1220a are arranged along the second direction F2, and at least one of the first passivation contact portions 1220a is arranged to extend longitudinally along the third direction F3. The second direction F2 and the third direction F3 intersect each other and are both perpendicular to the first direction F1.

The first passivation contact portion 1220a is longitudinally extended along the third direction F3, that is, the first passivation contact portion 1220a is configured to be in a strip shape substantially. Exemplarily, in combination with the contents illustrated in some of the aforementioned embodiments, the second direction F2 and the third direction F3 may be perpendicular to each other. For example, part of the first passivation contact portions 1220a may be arranged at intervals along the second direction F2, alternatively, all of the first passivation contact portions 1220a may be arranged at intervals along the second direction F2. Taking FIG. 2 and FIG. 3 as examples, the case where all of the first passivation contact portions 1220a are arranged at intervals along the second direction F2 is illustrated.

In this way, the optical parasitic absorption of the first doped conductive layer 1222a can be reduced while the current is reduced less, which is beneficial to increasing the fill factor of the cell, thereby helping to improve the efficiency of the cell.

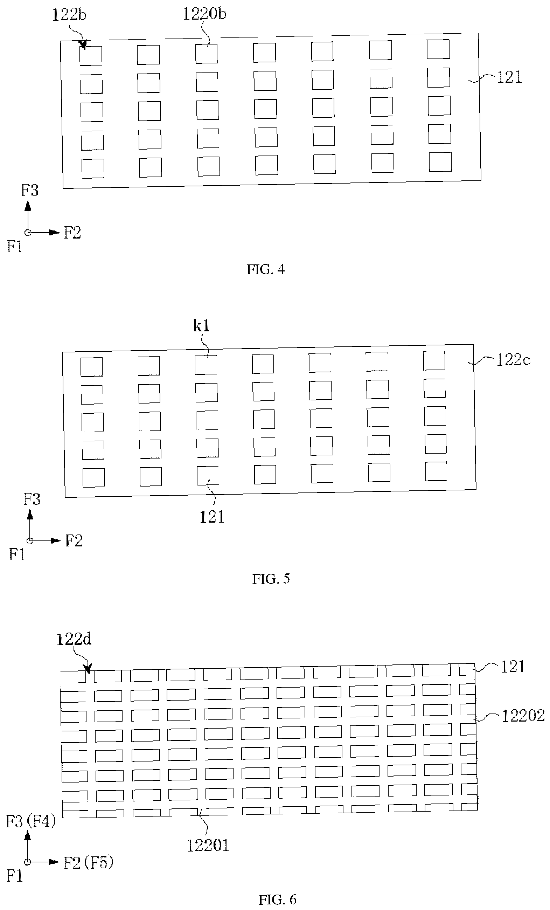

FIG. 4 is a schematic top view showing a cooperation of the substrate 121 and the first passivation contact layer 122b in other embodiments of the present invention. According to some embodiments of the present invention, referring to FIG. 4, the first passivation contact layer 122b includes a plurality of first passivation contact portions 1220b. All first passivation contact portions 1220b are arranged in rows and columns along the second direction F2 and the third direction F3, respectively. When the second direction F2 and the third direction F3 are perpendicular to each other, all first passivation contact portions 1220b are arranged in a rectangular array.

For example, the cross sections of the first passivation contact portions 1220b perpendicular to the first direction F1 may be in rectangular, circular, triangular shapes or other shapes, which are not specifically limited herein. Exemplarily, FIG. 4 illustrates the case where the cross sections of the first passivation contact portions 1220b perpendicular to the first direction F1 are rectangular.

In this case, compared with the strip-shaped first passivation contact portions 1220a illustrated in some of the aforementioned embodiments, the first passivation contact portions 1220b illustrated in FIG. 4 can achieve further beneficial effects of reducing the optical parasitic absorption of the first doped conductive layer 1222a. Of course, the strip-shaped first passivation contact portions 1220a illustrated in some of the aforementioned embodiments enable the cell to have a larger fill factor.

FIG. 5 is a schematic top view showing a cooperation of the substrate 121 and the first passivation contact layer 122c in some other embodiments of the present invention. According to some embodiments of the present invention, referring to FIG. 5, a plurality of first through holes k1 are formed in the first passivation contact layer 122c and penetrate the first passivation contact layer 122c along the first direction F1.

The first through hole k1 penetrates the first passivation contact layer 122c, that is, the first through hole k1 may expose a portion of the first surface m1 of the substrate 121 located opposite to the first through hole k1. In this case, in combination with the cases illustrated in some of the aforementioned embodiments, the side surfaces of the first passivation contact layer 122c located in the tandem solar cell can be understood as the inner side walls of the first through holes k1, respectively.

Exemplarily, the cross section of the first through hole k1 perpendicular to the first direction F1 may be in a rectangle, a circle, a triangle, or any other shape, which is not specifically limited herein. Taking FIG. 5 as an example, a case where the cross section of the first through hole k1 perpendicular to the first direction F1 is a rectangle is illustrated. The arrangement of the first through holes k1 may be understood and implemented with reference to the arrangement of the first passivation contact portions 1220a and the first passivation contact portions 1220b illustrated in some of the aforementioned embodiments, which is not specifically limited herein. In the case illustrated in FIG. 5, the plurality of first through holes k1 are arranged in a rectangular array.

In this way, the optical absorption of the first doped conductive layer 1222a can be reduced by forming through holes.

FIG. 6 is a schematic top view showing a cooperation of the substrate 121 and the first passivation contact layer 122d in some other embodiments of the present invention. According to some embodiments of the present invention, referring to FIG. 6, the first passivation contact layer 122d includes a plurality of first sub-portions 12201 and a plurality of second sub-portions 12202. The first sub-portions 12201 are extended along the fourth direction F4 and arranged at intervals along the fifth direction F5. The second sub-portions 12202 are arranged at intervals along the fourth direction F4. At least one of second sub-portion 12202 is connected to at least one of the first sub-portions 12201. The fourth direction F4 and the fifth direction F5 intersect each other and are both perpendicular to the first direction F1.

Exemplarily, the fourth direction F4 and the fifth direction F5 are perpendicular to each other. Taking FIG. 6 as an example, the fourth direction F4 is the same as the third direction F3, and the fifth direction F5 is the same as the second direction F2.

The first sub-portion 12201 and the second sub-portion 12202 are both arranged to be in a strip shape substantially. When each second sub-portion 12202 is connected to any one of the first sub-portions 12201, the first sub-portions 12201 and the second sub-portions 12202 substantially form a grid structure, which, compared with the case illustrated in FIG. 4, is beneficial to reducing shading while increasing the contact area, thereby facilitating the increase of the fill factor of the cell.

The structure of the first passivation contact layer may be but is not limited to the structure illustrated in some of the above embodiments, and may also be other structures, which are not specifically limited herein. When the structures illustrated in some of the above embodiments are adopted to form the first passivation contact layer, in addition to the advantages illustrated in some of the above embodiments, it is also beneficial to manufacture the first passivation contact layer. In addition, since the first passivation contact layer has good lateral conductivity, compared with the first passivation contact layer that completely covers the first surface m1 of the substrate 121, the first passivation contact layer in the embodiments of the present invention not only has a certain charge transport and collection capability, but also can reduce light parasitic absorption, thereby increasing the short-circuit current.

According to some embodiments of the present invention, continuing to refer to FIG. 1 and FIG. 2, the material of the first passivation layer 140 includes metal oxide, non-metal nitrides or non-metal nitrogen oxides.

Exemplarily, the metal oxide may be material such as aluminum oxide, yttrium oxide, ytterbium oxide, silicon oxide, etc. The non-metal nitrides may be material such as silicon nitride, aluminum nitride, etc. The non-metal nitrogen oxides may be material such as silicon oxynitride, aluminum oxynitride, etc. No limitations are specifically provided herein.

When the material of the first passivation layer 140 includes metal oxide, the metal oxide can provide high-density negative charges, thereby achieving field passivation. When the material of the first passivation layer 140 includes non-metal nitrides or non-metal nitrogen oxides, the non-metal nitrides or the non-metal nitrogen oxides can provide hydrogen atoms, and the hydrogen atoms can diffuse to the surface of the first passivation contact layer to passivate the dangling bonds, thereby achieving chemical passivation.

According to some embodiments of the present invention, continuing to refer to FIGS. 1 and 2, the material of the first passivation layer 140 includes metal oxide, and the thickness of the first passivation layer 140 is in a range from 1 nm to 50 nm. Alternatively, the material of the first passivation layer 140 includes non-metal nitrides or non-metal nitrogen oxides, and the thickness of the first passivation layer 140 is in a range from 50 nm to 100 nm.

The thickness of the first passivation layer 140 refers to a dimension extending, based on the first target surface t1 and the first sub-surface m11, in a direction perpendicular to the surface formed by the first target surface t1 and the first sub-surface m11 and along with the undulation of the formed surface. Since the surface formed by the first target surface t1 and the first sub-surface m11 is a surface with undulations, there are multiple directions perpendicular to the formed surface, which can be specifically determined according to shapes of corresponding portions. For example, in combination with the contents illustrated in some of the aforementioned embodiments, taking FIG. 2 as an example, the thickness of the portion of the first passivation layer 140 located on the top surface of the first passivation contact layer 122a is the dimension of the portion along the first direction F1, the thickness of the portion of the first passivation layer 140 located on the first sub-surface m11 is the dimension of the portion along the first direction F1, and the thickness of the portion of the first passivation layer 140 disposed on a side surface of the first passivation contact layer 122a is the dimension of the portion along the second direction F2. The first direction F1 is perpendicular to the top surface of the first passivation contact layer 122a, and the second direction F2 is perpendicular to the side surface of the first passivation contact layer 122a. Exemplarily, FIG. 2 illustrates that the thickness of the portion of the first passivation layer 140 located on the first sub-surface m11 is the first dimension h1.

Exemplarily, when the material of the first passivation layer 140 includes the metal oxide, the thickness of the first passivation layer 140 may be 1 nm, 2 nm, 5 nm, 10 nm, 15 nm, 20 nm, 25 nm, 30 nm, 45 nm, or 50 nm, or may be any other value in the range from 1 nm to 50 nm, which is not specifically limited herein. When the material of the first passivation layer 140 includes the non-metallic nitride or the non-metallic oxynitride, the thickness of the first passivation layer 140 may be 50 nm, 55 nm, 60 nm, 65 nm, 70 nm, 77 nm, 80 nm, 90 nm, or 100 nm, or may be any other value in the range from 50 nm to 100 nm, which is not specifically limited herein.

In this way, by controlling the thickness of the first passivation layer 140, the first passivation layer 140 can have a certain carrier transport capability while having a certain passivation effect.

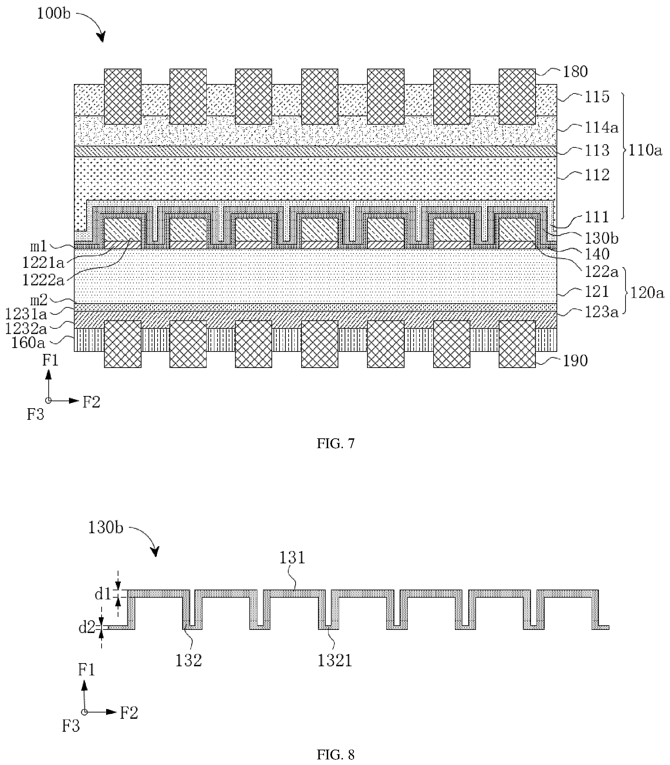

FIG. 7 is a schematic sectional view of a tandem solar cell 100b in some other embodiments of the present invention, and FIG. 8 is a schematic sectional view of a recombination layer 130b in the tandem solar cell 100b shown in FIG. 7. According to some embodiments of the present invention, referring to FIG. 7 and FIG. 8, the recombination layer 130b includes a first portion 131 and a second portion 132. An orthographic projection of the first portion 131 on the reference plane E and an orthographic projection of the first passivation contact layer 122a on the reference plane E coincide with each other. The thickness of a portion of the second portion 132, which is not in contact with the first passivation contact layer 122a, is less than the thickness of the first portion 131. In an embodiment, the recombination layer 130a shown in FIG. 1 or FIG. 2 may have the same structure as the recombination layer 130b.

Exemplarily, referring to FIG. 8, the thickness of the first portion 131 is the first thickness d1. The portion of the second portion 132, which is not in contact with the first passivation contact layer 122a, is the target portion 1321, and the thickness of the target portion 1321 is the second thickness d2. The second thickness d2 is less than the first thickness d1. In the case illustrated in FIG. 8, the thickness of the first portion 131 is a dimension of the first portion 131 along the first direction F1, the thickness of the target portion 1321 is the dimension of the second portion 132 along the first direction F1, and the thickness of the second portion 132 excluding the target portion 1321 is the dimension of the second portion 132 along the second direction F2. The thickness of the recombination layer 130b can be understood with reference to the thickness of the first passivation layer 140 illustrated above, and will not be described repeatedly in detail herein.

Exemplarily, the recombination layer 130b may be thinned by a laser etching process to form the first portion 131 and the second portion 132, or the first portion 131 and the second portion 132 may be formed by dual evaporation through a mask, which is not specifically limited herein. For the thickness range corresponding to each part of the recombination layer 130b, reference may be made to the thickness of the recombination layer 130b illustrated in some of the aforementioned embodiments, which is not described repeatedly in detail herein. It is only necessary that the thickness of the portion of the second portion 132, which is not in contact with the first passivation contact layer 122a, is less than the thickness of the first portion 131.

In this way, not only can the optical parasitic absorption of the recombination layer 130b be reduced, but also good lateral charge transport can be maintained. Moreover, since the thicker first portion 131 of the recombination layer 130b corresponds to the first passivation contact layer 122a, that is, corresponds to the related electrode structures (such as the first electrode 180 and the second electrode 190) illustrated hereinafter, it is beneficial to the longitudinal transport, thereby increasing the short-circuit current.

In the recombination layer 130a illustrated in FIGS. 1 and 2, the thickness of each portion of the recombination layer 130a is the same, which is different from the recombination layer 130b illustrated in FIGS. 7 and 8. No specific limitation is made herein. It can be understood that in the case of the recombination layer 130b illustrated in FIGS. 7 and 8, the optical parasitic absorption of the tandem solar cell can be further reduced by reducing the optical parasitic absorption of the recombination layer 130b.

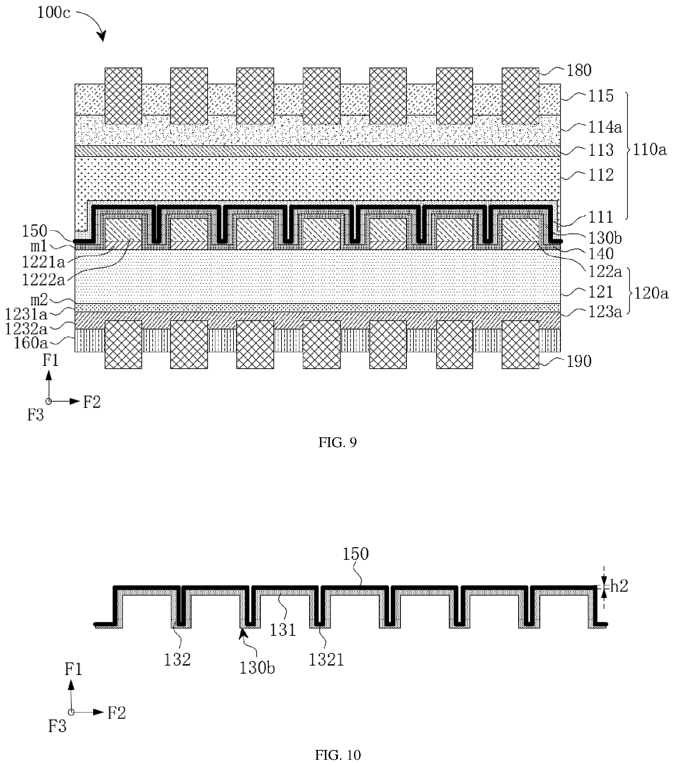

FIG. 9 is a schematic sectional view of a tandem solar cell 100c in some embodiments of the present invention, and FIG. 10 is a schematic sectional view showing a cooperation of the recombination layer 130b and a second passivation layer 150 in the tandem solar cell 100c shown in FIG. 9. According to some embodiments of the present invention, referring to FIGS. 9 and 10, the tandem solar cell 100c further includes a second passivation layer 150, and the second passivation layer 150 is disposed on a surface of the recombination layer 130b facing away from the bottom cell unit 120a. In an embodiment, the second passivation layer 150 may be disposed on a surface of the recombination layer 130a facing away from the bottom cell unit 120a shown in FIG. 1.

Exemplarily, oxygen defect sites of the recombination layer 130b may be eliminated by thermal annealing, and then the surface of the recombination layer 130b may be passivated by the second passivation layer 150.

In this way, by arranging the second passivation layer 150, not only can the surface defects of the recombination layer 130b be passivated to reduce the recombination centers, but also the second passivation layer 150, cooperating with the first passivation layer 140, enables the recombination layer 130b to be located between the first passivation layer 140 and the second passivation layer 150, forming an alternating structure, thereby further reducing the potential energy barrier in the tandem solar cell, facilitating the rapid transport of minority carriers as a whole, improving the open-circuit voltage, the fill factor and the short circuit current of the tandem solar cell, and helping to improve the efficiency of the cell.

According to some embodiments of the present invention, continuing to refer to FIG. 9 and FIG. 10, the second passivation layer 150 is configured as a monomolecular layer.

Exemplarily, the material of the monomolecular layer includes one or more of [4-(3,6-dimethyl-9H-carbazole-9-yl) butyl] phosphonic acid (Me-4PACz), [2-(3,6-dimethoxy-9H-carbazole-9-yl) ethyl] phosphonic acid (MeO-2PACz), or [2-(9H-carbazole-9-yl) ethyl] phosphonic acid (2PACz). In this way, the oxygen defect points of the recombination layer 130b may be eliminated by thermal annealing, and then the oxygen vacancies on the surface of the recombination layer 130b may be preferentially adsorbed by, for example, phosphonic acid (H₂PO₃) molecules to saturate the dangling bonds and reduce the interface state density. Alternatively, an interface dipole may be formed on the surface of the recombination layer 130b by a molecular layer of fluorine, carboxyl or phosphonic acid to improve the work function.

In this way, the second passivation layer 150 is configured as the monomolecular layer, which is beneficial to improve the carrier transport efficiency and the interface stability.

In some other embodiments, the second passivation layer 150 may also be made of other materials. Since the second passivation layer 150 cooperates with the recombination layer 130b, configuring the second passivation layer 150 as the monomolecular layer will achieve advantages as mentioned above.

According to some embodiments of the present invention, continuing to refer to FIG. 10, the thickness of the second passivation layer 150 is in a range from 0.3 nm to 2 nm.

Exemplarily, the thickness of the second passivation layer 150 may be 0.3 nm, 0.5 nm, 1 nm, 1.5 nm, 1.8 nm, 1.9 nm, or 2 nm.

Since the second passivation layer 150 changes with the surface undulation of the recombination layer 130b, for the understanding of the thickness of the second passivation layer 150, reference may be made to the understanding of the thickness of the recombination layer 130b illustrated above, which will not repeatedly described herein. Exemplarily, as shown in FIG. 9 and FIG. 10, the thickness of the portion of the second passivation layer 150 opposite to the first passivation contact layer 122a along the first direction F1 is the second dimension h2.

In this way, by controlling the thickness of the second passivation layer 150, the second passivation layer 150 can have a certain carrier transport capability while having a certain passivation effect.

According to some embodiments of the present invention, continuing to refer to FIGS. 1, 7 and 9, the bottom cell unit 120a also includes a second passivation contact layer 123a, and the second passivation contact layer 123a includes a second tunneling layer 1231a and a second doped conductive layer 1232a stacked and disposed on the surface of the substrate 121 facing away from the top cell unit 110a.

For the understanding of the second tunneling layer 1231a and the second doped conductive layer 1232a, reference can be made to the understanding of the first tunneling layer 1221a and the first doped conductive layer 1222a illustrated above, which will not be repeatedly described herein. In an embodiment of the present invention, the second doped conductive layer 1232a may be formed by doping amorphous silicon, microcrystalline silicon, polycrystalline silicon, etc. with a P-type dopant. Exemplarily, the second doped conductive layer 1232a is a boron-doped polycrystalline silicon layer. In this case, the stacked second tunneling layer 1231a and the second doped conductive layer 1232a together form a passivation contact structure, and the passivation contact structure provides good surface passivation for the second surface m2 of the substrate 121.

Exemplarily, a dimension of the second doped conductive layer 1232a along the first direction F1, namely the thickness of the second doped conductive layer 1232a, is in a range from 50 nm to 400 nm. For example, the thickness of the second doped conductive layer 1232a may be 50 nm, 60 nm, 70 nm, 80 nm, 100 nm, 120 nm, 200 nm, 260 nm, 350 nm, 390 nm or 400 nm, or may also be any other value within the range from 50 nm to 400 nm, which is not specifically limited herein.

According to some embodiments of the present invention, continuing to refer to FIG. 1, FIG. 7 and FIG. 9, the bottom cell unit 120a further includes a third passivation layer 160a. The third passivation layer 160a is arranged on a surface of the second doped conductive layer 1232a facing away from the second tunneling layer 1231a, and the third passivation layer 160a may be a single-layer structure or a multi-layer structure. The material of the third passivation layer 160a includes metal oxide, non-metal nitrides or non-metal nitrogen oxides. The third passivation layer 160a can functions as passivation.

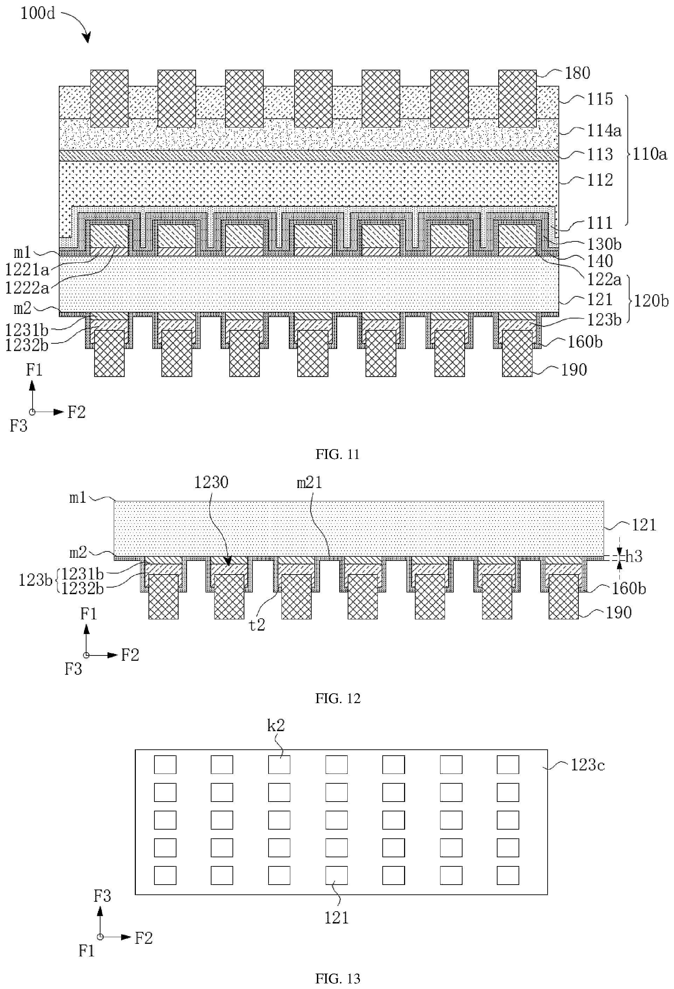

FIG. 11 is a schematic sectional view of a tandem solar cell 100d in some other embodiments of the present invention, and FIG. 12 is a schematic sectional view of a partial structure of the tandem solar cell 100d shown in FIG. 11. According to some embodiments of the present invention, referring to FIG. 11 and FIG. 12, the bottom cell unit 120b further includes a second passivation contact layer 123b, and the second passivation contact layer 123b includes a second tunneling layer 1231b and a second doped conductive layer 1232b stacked and disposed on a surface of the substrate 121 facing away from the top cell unit 110a. An orthographic projection of the second passivation contact layer 123b on the reference plane E is located within the range of the overlapping projection, and the area of the orthographic projection of the second passivation contact layer 123b on the reference plane E is smaller than the area of the overlapping projection.

That is, the second tunneling layer 1231b is disposed on the second surface m2 of the substrate 121, and the second doped conductive layer 1232b is disposed on a surface of the second tunneling layer 1231b facing away from the substrate 121.

The relationship between the orthographic projection of the second passivation contact layer 123b on the reference plane E and the overlapping projection, and the related manufacturing manners and the related implementation manners of the second passivation contact layer 123b may be understood by referring to the relationship between the orthographic projection of the first passivation contact layer 122a on the reference plane E and the overlapping projection, and the related manufacturing manners and the related implementation manners of the first passivation contact layer 122a illustrated in some of the aforementioned embodiments, respectively, which will not be repeatedly described herein. The difference is that the doping type of the first doped conductive layer 1222a and the doping type of the second doped conductive layer 1232a are different.

In this way, by configuring the area of the orthographic projection of the second passivation contact layer 123b on the reference plane E to be smaller than the area of the overlapping projection of the top cell unit 110a and the bottom cell unit 120b, the second passivation contact layer 123b covers partial region of the surface of the substrate 121 facing away from the top cell unit 110a, so that: not only the optical parasitic absorption of the second doped conductive layer 1232b is reduced and the optical loss of the cell is reduced, thereby increasing the short-circuit current of the cell, but also the physical contact area and electrical connection efficiency of the interface are increased and the resistance between the interfaces is reduced, which is beneficial to the transport and collection of minority carriers in the cell, thereby increasing the fill factor of the cell.

Since the second passivation contact layer 123b has good lateral conductivity, compared with the second passivation contact layer 123a that covers the entire second surface m2 of the substrate 121, the second passivation contact layer 123b provided in the embodiment of the present invention not only has a certain charge transport and collection capability, but also can reduce light parasitic absorption, thereby increasing the short-circuit current.

According to some embodiments of the present invention, continuing to refer to FIGS. 11 and 12, the second passivation contact layer 123b includes a plurality of second passivation contact portions 1230 arranged at intervals. That is, all second passivation contact portions 1230 are spaced apart, all second passivation contact portions 1230 are separately arranged, and all second passivation contact portions 1230 define intervals.

Due to the absence of the second passivation contact portions 1230 in the intervals, optical parasitic absorption of the second doped conductive layer 1232b can be further reduced.

For the relevant implementations and advantages of the second passivation contact portion 1230, reference may be made to the implementations and advantages of the first passivation contact portion 1220a and the first passivation contact portion 1220b illustrated in some of the aforementioned embodiments, which will not be repeatedly described herein.

FIG. 13 is a schematic top view showing a cooperation of the substrate 121 and the second passivation contact structure in other embodiments of the present invention. According to some embodiments of the present invention, referring to FIG. 13, a plurality of second through holes k2 are formed in the second passivation contact layer 123c and penetrate the second passivation contact layer 123c along the first direction F1.

The second through hole k2 penetrates the second passivation contact layer 123c, that is, the second through hole k2 can expose a portion of the second surface m2 of the substrate 121 located opposite to the second through hole k2.

Exemplarily, the cross section of the second through hole k2 perpendicular to the first direction F1 may be in a rectangle, a circle, a triangle or any other shape, which is not specifically limited herein. Taking FIG. 13 as an example, a case where the cross section of the second through hole k2 perpendicular to the first direction F1 is in a rectangle shape is illustrated. The arrangement of the second through hole k2 may be understood and implemented with reference to the arrangement of the second passivation contact portion 1230 illustrated in some of the aforementioned embodiments, which is not specifically limited herein. In the case illustrated in FIG. 13, the plurality of second through holes k2 are arranged in a rectangular array.

In this way, the optical absorption of the second doped conductive layer 1232b can be reduced by forming through holes.

According to some embodiments of the present invention, continuing to refer to FIG. 11 and FIG. 12, a portion of the surface of the substrate 121 facing away from the top cell unit 110a, which is exposed by the second passivation contact layer 123b, is the second sub-surface m21. The second passivation contact layer 123b has a second target surface t2 that is not in contact with the surface of the substrate 121 facing away from the top cell unit 110a and located in the tandem solar cell 100d. The tandem solar cell 100d further includes a third passivation layer 160b, and the third passivation layer 160b is disposed on the second sub-surface m21 and the second target surface t2.

Referring to the manufacture of the first passivation contact layer, the risk of generating damages during the manufacture of the second passivation contact layer 123b may be understood with reference to the risk of damages of the first passivation contact layer. Therefore, by arranging the third passivation layer 160b, not only can the defects be controlled more uniformly, but also the stresses at the boundary of the damaged and undamaged portions can be improved, thereby improving the consistency and reliability of the second passivation contact layer 123b.

The second target surface t2 may be understood with reference to the first target surface t1, which will not be repeatedly described herein.

According to some embodiments of the present invention, continuing to refer to FIG. 11 and FIG. 12, the material of the third passivation layer 160b includes metal oxide, non-metal nitrides or non-metal nitrogen oxides.

Exemplarily, the metal oxide may be material such as aluminum oxide, yttrium oxide, ytterbium oxide, silicon oxide, etc. The non-metal nitrides may be material such as silicon nitride, aluminum nitride, etc. The non-metal nitrogen oxides may be material such as silicon oxynitride, aluminum oxynitride, etc. No limitations are specifically provided herein.

When the material of the third passivation layer 160b includes metal oxide, the metal oxide can provide high-density negative charges, thereby achieving field passivation. When the material of the third passivation layer 160b includes non-metal nitrides or non-metal nitrogen oxides, the non-metal nitrides or non-metal nitrogen oxides can provide hydrogen atoms, and the hydrogen atoms can diffuse to the surface of the second passivation contact layer to passivate the dangling bonds, thereby achieving chemical passivation.

According to some embodiments of the present invention, continuing to refer to FIGS. 11 and 12, the material of the third passivation layer 160b includes metal oxide, and the thickness of the third passivation layer 160b is in a range from 1 nm to 50 nm. Alternatively, the material of the third passivation layer 160b includes non-metal nitrides or non-metal nitrogen oxides, and the thickness of the third passivation layer 160b is in a range from 50 nm to 100 nm.

For the understanding of the thickness of the third passivation layer 160b, reference may be made to the understanding of the thickness of the first passivation layer 140, which will not be described repeatedly in detail. Exemplarily, FIG. 12 illustrates that the thickness of a portion of the third passivation layer 160b located on the second sub-surface m21 is the third dimension h3.

Exemplarily, when the material of the third passivation layer 160b includes metal oxide, the thickness of the third passivation layer 160b may be 1 nm, 2 nm, 5 nm, 10 nm, 15 nm, 20 nm, 25 nm, 30 nm, 45 nm, or 50 nm, or may be any other value in the range from 1 nm to 50 nm, which is not specifically limited herein. When the material of the third passivation layer 160b includes non-metallic nitride or non-metallic oxynitride, the thickness of the third passivation layer 160b may be 50 nm, 55 nm, 60 nm, 65 nm, 70 nm, 77 nm, 80 nm, 90 nm, or 100 nm, or may be any other value in the range from 50 nm to 100 nm, which is not specifically limited herein.

In this way, by controlling the thickness of the third passivation layer 160b, the third passivation layer 160b can have a certain carrier transport capability while having a certain passivation effect.

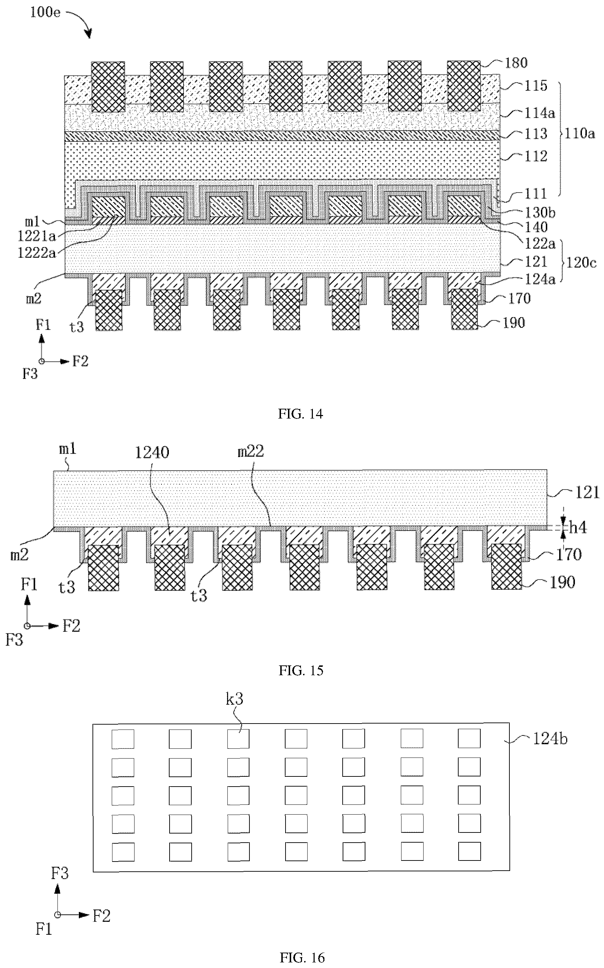

FIG. 14 is a schematic sectional view of a tandem solar cell 100e in some other embodiments of the present invention, and FIG. 15 is a schematic sectional view of a partial structure of the tandem solar cell 100e shown in FIG. 14. According to some embodiments of the present invention, referring to FIG. 14 and FIG. 15, the bottom cell unit 120c further includes a doped layer 124a disposed on the surface of the substrate 121 facing away from the top cell unit 110a. An orthographic projection of the doped layer 124a on the reference plane E is located within the range of the overlapping projection, and the area of the orthographic projection of the doped layer 124a on the reference plane E is smaller than the area of the overlapping projection.

The doping type of the doped layer 124a is different from the doping type of the first doped conductive layer 1222a. Exemplarily, the doping type of the first doped conductive layer 1222a is N-type, and the doping type of the doped layer 124a is P-type.

Exemplarily, the doped layer 124a includes a doped diffusion layer. For example, a diffusion process may be performed on the second surface m2 of the substrate 121 in a diffusion furnace containing a P-type dopant to form the doped diffusion layer, and the doped layer 124a may be a boron diffusion layer. Taking FIG. 14 and FIG. 15 as examples, the doped layer 124a is formed by performing the diffusion process on the second surface m2 of the substrate 121.

A relationship between the orthographic projection of the doped layer 124a on the reference plane E and the overlapping projection, and the related manufacturing manners and the related implementation manners of the doped layer 124a may be understood by referring to the relationship between the orthographic projection of the first passivation contact layer on the reference plane E and the overlapping projection, and the related manufacturing manners and the related implementation manners of the first passivation contact layer illustrated in some of the aforementioned embodiments, respectively, which will not be repeatedly described herein. A difference is that the formation process of the doped layer 124a differs from the formation process of the first passivation contact layer, but how to make the area of the orthographic projection of the doped layer 124a on the reference plane E smaller than the area of the overlapping projection can be implemented by referring to the implementation of the first passivation contact layer, which will not be repeatedly described herein.

In this way, by configuring the area of the orthographic projection of the doped layer 124a on the reference plane E to be smaller than the area of the overlapping projection of the top cell unit 110a and the bottom cell unit 120c, the doped layer 124a covers partial region of the surface of the substrate 121 facing away from the top cell unit 110a, so that: not only the optical parasitic absorption of the doped layer 124a is reduced and the optical loss of the cell is reduced, thereby increasing the short-circuit current of the cell, but also the physical contact area and electrical connection efficiency of the interface are increased and the resistance between the interfaces is reduced, which is beneficial to the transport and collection of minority carriers in the cell, thereby increasing the fill factor of the cell.

According to some embodiments of the present invention, continuing to refer to FIGS. 14 and 15, the doped layer 124a includes a plurality of doped portions 1240 arranged at intervals. That is, all doped portions 1240 are spaced apart, all doped portions 1240 are separately arranged, and all doped portions 1240 define intervals.

Due to the absence of the doped portions 1240 in the intervals, optical parasitic absorption of the doped layer 124a can be further reduced.

For the relevant embodiments and advantages of the doped portion 1240, reference may be made to the implementations and advantages of the first passivation contact portion 1220a and the first passivation contact portion 1220b illustrated in some of the aforementioned embodiments, which will not be repeatedly described herein. For example, all doped portions 1240 may be arranged in a rectangular array. For another example, the doped portion 1240 may be adapted to have a strip shape as the first passivation contact portion 1220a. No specific limitations are made herein.

FIG. 16 is a schematic top view showing a cooperation of the substrate 121 and the doped layer 124b in some other embodiments of the present invention. According to some embodiments of the present invention, referring to FIG. 16, a plurality of third through holes k3 are formed in the doped layer 124b and penetrate the doped layer 124b along the first direction F1.

The third through hole k3 penetrates the doped layer 124 b, that is, the third through hole k3 may expose a portion of the second surface m2 of the substrate 121 located opposite to the third through hole k3.

Exemplarily, the cross section of the third through hole k3 perpendicular to the first direction F1 may be in a rectangle, a circle, a triangle or any other shape, which is not specifically limited herein. Taking FIG. 16 as an example, a case where the cross section of the third through hole k3 perpendicular to the first direction F1 is in a rectangle shape is illustrated. The arrangement of the third through hole k3 may be understood and implemented with reference to the arrangement of the second passivation contact portion 1230 illustrated in some of the aforementioned embodiments, which are not specifically limited herein. In the case illustrated in FIG. 16, the plurality of third through holes k3 are arranged in a rectangular array.

In this way, the optical absorption of the doped layer 124b can be reduced by forming the through holes.

According to some embodiments of the present invention, continuing to refer to FIG. 14 and FIG. 15, a portion of the surface m2 of the substrate 121 facing away from the top cell unit 110a, which is exposed by the doped layer 124a, is a third sub-surface m22. The doped layer 124a has a third target surface t3 that is not in contact with the surface m2 of the substrate 121 facing away from the top cell unit 110a and located in the tandem solar cell 100e. The tandem solar cell 100e further includes a fourth passivation layer 170, and the fourth passivation layer 170 is disposed on the third sub-surface m22 and the third target surface t3.

When the diffusion process is performed on the second surface m2 of the substrate 121 to form a doped diffusion layer to obtain the doped layer 124a, the surface of the doped layer 124a facing away from the top cell unit 110a is the top surface. In this case, the third target surface t3 may be regarded as a part of the second surface m2. The third sub-surface m22 is a portion of the surface of the substrate 121 exposed by the doped layer 124a. Surfaces of the doped layer 124a include a top surface facing away from the top cell unit 110a and side surfaces connected to the top surface. According to the structure of the doped layer 124a, all side surfaces of the doped layer 124a may be entirely located in the tandem solar cell 100e, or a part of the side surfaces of the doped layer 124a may be located in the tandem solar cell 100e, and the other part thereof is not located in the tandem solar cell 100e. Exemplarily, as shown in FIG. 14 and FIG. 15, the side surfaces of the doped layer 124a are entirely located in the tandem solar cell 100e. When the other part of the side surfaces of the doped layer 124a is not located in the tandem solar cell 100e, the other part of the side surfaces may be flush with the side surfaces of the tandem solar cell 100e. That is, the third target surface t3 includes the aforementioned top surface of the doped layer 124a and the side surfaces of the doped layer 124a located in the tandem solar cell. When the doped layer 124a is formed on the second surface m2 of the substrate 121, the third sub-surface m22 and the third target surface t3 may be understood with reference to the first sub-surface m11 and the first target surface t1, and the second sub-surface m21 and the second target surface t2 described above, which will not be repeatedly described herein.

During manufacture of the doped layer 124a, as shown for the manufacture of the first passivation contact layer, using the laser etching process has the risk of causing thermal damage, mechanical stress damage, plasma damage, etc., and using the mask process has the risk of causing etching damage, thermal stress damage, etc., thus generating the risk of damaging the doped layer 124a. Similarly, by arranging the fourth passivation layer 170 and controlling the hydrogen content or charge density in the fourth passivation layer 170, the damaged and undamaged portions on the surface of the doped layer 124a are both passivated.

In this way, by arranging the first passivation layer 140, not only can the defects be controlled more uniformly and the stresses at the boundary of the damaged and undamaged portions be improved, thereby improving the consistency and reliability of the doped layer, but also the potential energy barrier between the film layers can be reduced, which is beneficial to the transport and collection of minority carriers in the cell, thereby increasing the open-circuit voltage and the fill factor of the cell.

According to some embodiments of the present invention, continuing to refer to FIG. 14 and FIG. 15, the material of the fourth passivation layer 170 includes metal oxide, non-metal nitrides or non-metal nitrogen oxides.

Exemplarily, the metal oxide may be material such as aluminum oxide, yttrium oxide, ytterbium oxide, silicon oxide, etc. The non-metal nitrides may be material such as silicon nitride, aluminum nitride, etc. The non-metal nitrogen oxides may be material such as silicon oxynitride, aluminum oxynitride, etc. No limitations are specifically provided herein.

When the material of the fourth passivation layer 170 includes metal oxide, the metal oxide can provide high-density negative charges, thereby achieving field passivation. When the material of the fourth passivation layer 170 includes non-metal nitrides or non-metal nitrogen oxides, the non-metal nitrides or non-metal nitrogen oxides can provide hydrogen atoms, and the hydrogen atoms can diffuse to the surface of the second passivation contact layer to passivate the dangling bonds, thereby achieving chemical passivation.

According to some embodiments of the present invention, continuing to refer to FIGS. 14 and 15, the material of the fourth passivation layer 170 includes metal oxide, and the thickness of the fourth passivation layer 170 is in a range from 1 nm to 50 nm. Alternatively, the material of the fourth passivation layer 170 includes non-metal nitrides or non-metal nitrogen oxides, and the thickness of the fourth passivation layer 170 is in a range from 50 nm to 100 nm.

For the connotation and understanding of the thickness of the fourth passivation layer 170, reference may be made to the thickness of the first passivation layer 140 illustrated in some of the aforementioned embodiments, which will not be described repeatedly in detail. Exemplarily, FIG. 15 illustrates that the thickness of a portion of the fourth passivation layer 170 located on the substrate 121 is the dimension of the portion along the first direction F1 (i.e., the fourth dimension h4).

Exemplarily, when the material of the fourth passivation layer 170 includes metal oxide, the thickness of the fourth passivation layer 170 may be 1 nm, 2 nm, 5 nm, 10 nm, 15 nm, 20 nm, 25 nm, 30 nm, 45 nm, or 50 nm, or may be any other value in the range from 1 nm to 50 nm, which is not specifically limited herein. When the material of the fourth passivation layer 170 includes non-metallic nitride or non-metallic oxynitride, the thickness of the fourth passivation layer 170 may be 50 nm, 55 nm, 60 nm, 65 nm, 70 nm, 77 nm, 80 nm, 90 nm, or 100 nm, or may be any other value in the range from 50 nm to 100 nm, which is not specifically limited herein.

In this way, by controlling the thickness of the fourth passivation layer 170, the fourth passivation layer 170 can have a certain carrier transport capability while having a certain passivation effect.

According to some embodiments of the present invention, continuing to refer to FIGS. 1, 7, 9, 11 and 14, the top cell unit 110a includes a first charge transport layer 111, a light absorption layer 112, a second charge transport layer 113 and a transparent electrode layer 114a stacked away from the bottom cell unit.

The first charge transport layer 111 and the second charge transport layer 113 can transport carriers. Sunlight can pass through the transparent electrode layer 114a, so that the light absorption layer 112 is irradiated by the sunlight, thereby generating a photocurrent in the tandem solar cell. Specifically, the light absorption layer 112 can generate electron-hole pairs under the irradiation of sunlight. Electrons and holes may be called carriers. The recombination layer may be configured to modify the surface of the top cell unit 110a facing the bottom cell unit. The electrons and holes of the top cell unit 110a can be recombined in the recombination layer to make the current of the bottom cell unit consistent with the current of the top cell unit 110a as much as possible.

Exemplarily, the first charge transport layer 111 and the second charge transport layer 113 may transport carriers and may be manufactured by one of Physical Vapor Deposition (PVD) process, Rapid Plasma Deposition (RPD) process, thermal evaporation process, close space sublimation process, vapor transport deposition process, or spraying process. The material of the first charge transport layer 111 and the material of the second charge transport layer 113 may be at least one of PTAA, NiOₓ, V₂O₅, MoOₓ, PEDOT: PSS, WOₓ, CuSCN, Cu₂O, CuI, or Spiro-TTB. Specifically, as known from the materials of the first charge transport layer 111 and the second charge transport layer 113, the above-mentioned film layers can transport electrons or holes. For example, the first charge transport layer 111 is a hole transport layer, and the second charge transport layer 113 is an electron transport layer.

Exemplarily, a dimension of the first charge transport layer 111 along the first direction F1, namely the thickness of the first charge transport layer 111, is in a range from 15 nm to 35 nm. For example, the thickness of the first charge transport layer 111 may be 15 nm, 20 nm, 22 nm, 25 nm, 28 nm, 30 nm, 33 nm or 35 nm, or may be any other value within the range from 15 nm to 35 nm, which is not specifically limited herein.

Exemplarily, a dimension of the second charge transport layer 113 along the first direction F1, namely the thickness of the second charge transport layer 113, is in a range from 10 nm to 30 nm. For example, the thickness of the second charge transport layer 113 may be 10 nm, 15 nm, 20 nm, 22 nm, 25 nm, 28 nm, or 30 nm, or may be any other value within the range from 10 nm to 30 nm, which is not specifically limited herein.

Exemplarily, the light absorption layer 112 may be a perovskite layer. The chemical formula of the perovskite in the light absorption layer 112 is ABX₃, where, A includes an organic cation, an inorganic cation or an organic-inorganic mixed cation, B includes an organic cation, an inorganic cation or an organic-inorganic mixed cation, and X includes an organic anion, an inorganic anion or an organic-inorganic mixed anion. A may include any one of or a combination of at least two of FA⁺, MA⁺, Cs⁺ or Rb⁺, B may include any one of or a combination of at least two of Pb²⁺, Sn²⁺ or Sr²⁺, and X may include any one of or a combination of at least two of Br⁻, I⁻ or CI⁻. According to actual needs, a perovskite material having corresponding ions may be selected to prepare the perovskite layer (i.e., the light absorption layer 112), which is not specifically limited herein.

Exemplarily, a dimension of the light absorption layer 112 along the first direction F1, namely the thickness of the light absorption layer 112, is in a range from 500 nm to 1300 nm. For example, the thickness of the light absorption layer 112 may be 500 nm, 600 nm, 650 nm, 700 nm, 800 nm, 900 nm, 1000 nm, 1100 nm, 1200 nm or 1300 nm, or may also be any other value within the range from 500 nm to 1300 nm, which is not specifically limited herein.

Exemplarily, the material of the transparent electrode layer 114a includes a transparent metal oxide. Specifically, the material of the transparent electrode layer 114a may include at least one of ITO, IZO, AZO, IWO, SnO₂, ZnO, strontium indium oxide, or IXO. The transparent electrode layer 114a may be manufactured by a PVD process or an RPD process.

Exemplarily, the thickness of the transparent electrode layer 114a may be in a range from 30 nm to 100 nm. For example, the thickness of the transparent electrode layer 114a may be 30 nm, 40 nm, 50 nm, 60 nm, 70 nm, 75 nm, 80 nm, 90 nm, 95 nm or 100 nm, or may also be any other value within the range from 30 nm to 100 nm, which is not specifically limited herein.

In this way, the required structure of the top cell unit 110a may be obtained according to the above structure.

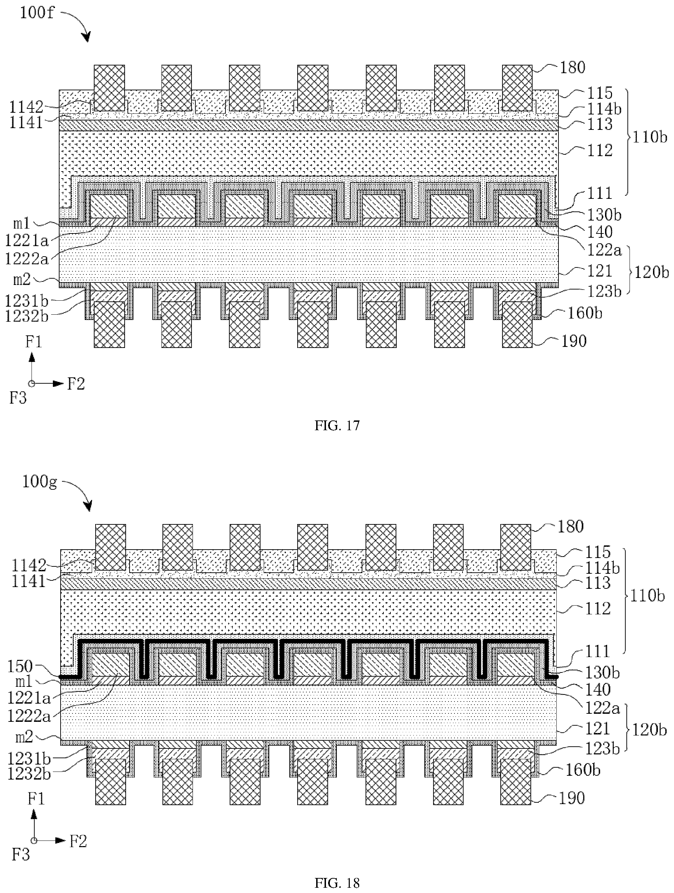

FIG. 17 is a schematic sectional view of a tandem solar cell 100f in some embodiments of the present invention. According to some embodiments of the present invention, referring to FIG. 17, the top cell unit 110b includes the first charge transport layer 111, the light absorption layer 112, the second charge transport layer 113, and the transparent electrode layer 114b stacked away from the bottom cell unit 120b. The transparent electrode layer 114b includes a first sublayer 1141 and a second sublayer 1142, the first sublayer 1141 is arranged on a surface of the second charge transport layer 113 facing away from the light absorption layer 112, and the second sublayer 1142 is arranged on a surface of the first sublayer 1141 facing away from the second charge transport layer 113. An orthographic projection of the first sublayer 1141 on the reference plane E coincides with the overlapping projection. An orthographic projection of the second sublayer 1142 on the reference plane E is located within the range of the overlapping projection, and an area of the orthographic projection of the second sublayer 1142 on the reference plane E is smaller than the area of the overlapping projection. In an embodiment, the transparent electrode layer 114a shown in FIGS. 1, 7, 9 and 11 may also have the same structure as the aforementioned transparent electrode layer 114b.

Thus, since the transparent electrode layer 114b includes the first sublayer 1141, the transparent electrode layer 114b has a certain film thickness, which is beneficial to lateral transmission. The transparent electrode layer 114b includes the second sublayer 1142, thereby reducing the light parasitic absorption while facilitating the charge transport.

The arrangement and construction of the second sublayer 1142 may be understood with reference to the first passivation contact portion 1220a and the first passivation contact portion 1220b illustrated in some of the aforementioned embodiments, and will not be repeatedly described herein. For example, the second sublayer 1142 may include a plurality of substructures arranged at intervals, and all substructures may be arranged in a rectangular array or adapted to have a strip shape, which is not limited herein. For another example, a through-hole structure may be formed on the second sublayer 1142, and the arrangement and implementation of the related through-hole structure may be understood with reference to the first through holes k1 illustrated in some of the aforementioned embodiments, and will not be specifically limited herein. The thickness of each layer in the top cell unit 110b illustrated in FIG. 17 may be understood with reference to the thickness of each layer in the aforementioned top cell unit 110a illustrated in the FIGS. 1, 7, 9, 11 and 14, which will not be repeatedly described herein. The sum of a thickness of the second sublayer 1142 and a thickness of a portion of the first sublayer 1141 which corresponds to the second sublayer 1142 in the transparent electrode layer 114b illustrated in FIG. 17 may be understood with reference to the thickness of the transparent electrode layer 114a illustrated above.

According to some embodiments of the present invention, continuing to refer to FIG. 17, the top cell unit 110b further includes a protective layer 115 disposed on a surface of the transparent electrode layer 114b facing away from the bottom cell unit 120b.

Exemplarily, a thickness of the protective layer 115 is in a range from 50 nm to 200 nm. For example, the thickness of the protective layer 115 may be 50 nm, 60 nm, 70 nm, 75 nm, 80 nm, 90 nm, 100 nm, 150 nm, 180 nm or 200 nm, or may also be any other value within the range from 50 nm to 200 nm, which is not specifically limited herein.

In this way, the protective layer 115 is arranged to protect the transparent electrode layer 114, thereby improving the reliability of the transparent electrode layer 114b.

The top cell unit 110a illustrated in FIGS. 1, 7, 9, 11 and 14 also includes the protective layer 115 arranged on the surface of the transparent electrode layer 114a facing away from the bottom cell unit.

According to some embodiments of the present invention, continuing to refer to FIG. 17, the tandem solar cell 100f further includes a first electrode 180. An orthographic projection of the first electrode 180 on the reference plane E is located within the range of the orthographic projection of the second sublayer 1142 on the reference plane E, and the first electrode 180 at least forms an ohmic contact with the second sublayer 1142.

Exemplarily, the material of the first electrode 180 includes at least one of Ag, Cu, Ni or Al. The first electrode 180 may be manufactured by a screen-printing process, an electroplating process, a laser transport process or a thermal evaporation process.

The transparent electrode layer 114b is configured for conducting electrons, and a dimension of a portion of the transparent electrode layer 114b corresponding to the first electrode 180 in the first direction F1 is relatively larger than those of other portions of the transparent electrode layer 114b, thereby helping to reduce parasitic absorption and facilitating a connection between the first electrode 180 and the transparent electrode layer 114b.

According to some embodiments of the present invention, continuing to refer to FIG. 17, the tandem solar cell 100f further includes a second electrode 190 arranged at a side of the substrate 121 facing away from the top cell unit 110b, and the second electrode 190 forms an ohmic contact with the second passivation contact layer 123b.

Exemplarily, the material of the second electrode 190 includes at least one of Ag, Cu, Ni or Al. The second electrode 190 may be manufactured by a screen-printing process, an electroplating process, a laser transport process or a thermal evaporation process.

The tandem solar cell illustrated in FIGS. 1, 7, 9, 11 and 14 also includes the second electrode 190 disposed at the side of the substrate 121 facing away from the top cell unit 110a. In the cases illustrated in FIGS. 1, 7 and 9, the second electrode 190 forms an ohmic contact with the second doped conductive layer 1232a. In the case illustrated in FIG. 11, the second electrode 190 forms an ohmic contact with the second doped conductive layer 1232b. In the case illustrated in FIG. 14, the second electrode 190 forms an ohmic contact with the doped layer 124a.

Some of the above embodiments respectively illustrate the case in which improvements are made to the first passivation contact layer, the second passivation contact layer, the doped layer, the recombination layer and the transparent electrode layer to reduce parasitic absorption. The improvement refers to the case in which, for a layer structure of full coverage, the layer structure partially covers a corresponding surface or the layer structure is partially removed. For example, the improvements to the first passivation contact layer (with reference to FIGS. 1, 7, 9, 11, 14 and 17), the second passivation contact layer (with reference to FIGS. 11 and 17) and the doped layer (with reference to FIG. 14) correspond to cases of partial coverage. In these cases, since these layer structures have good lateral transmission performance, they have little effect on the charge transport and collection, thereby reducing parasitic absorption while having certain lateral transmission performance, and improving the short circuit. For another example, the improvements to the recombination layer (with reference to FIGS. 7, 9, 11, 14 and 17) and the transparent electrode layer (with reference to FIG. 17) correspond to cases where part of the structure is removed, which is beneficial to reduce parasitic absorption while having a certain lateral transmission performance. When the tandem solar cell includes layer structures, such as the first passivation contact layer, the second passivation contact layer, the doped layer, the recombination layer and the transparent electrode layer, at least one of these layer structures can be improved. In this process, the layer structures can be improved by a laser etching process or a mask process, which is not specifically limited herein.

Exemplarily, when the tandem solar cell includes the first passivation contact layer, the second passivation contact layer, the recombination layer and the transparent electrode layer, at least one of the first passivation contact layer, the second passivation contact layer, the recombination layer or the transparent electrode layer may be improved to reduce parasitic absorption. That is, only the first passivation contact layer may be improved, or the first passivation contact layer and the second passivation contact layer may be improved, or the first passivation contact layer, the second passivation contact layer and the recombination layer may be improved, or the first passivation contact layer, the second passivation contact layer, the recombination layer and the transparent electrode layer may be improved, and so on, which is not limited herein. Exemplarily, FIG. 1 illustrates the case in which the first passivation contact layer 122a in the tandem solar cell 100a is improved. Exemplarily, FIGS. 7 and 9 illustrate the improvements to the first passivation contact layer 122a and the recombination layer 130b in the tandem solar cell 100b and in the tandem solar cell 100c. Exemplarily, FIG. 11 illustrates the improvements to the first passivation contact layer 122a, the recombination layer 130b and the second passivation contact layer 123b in the tandem solar cell 100d. Exemplarily, FIG. 17 illustrates the improvements to the first passivation contact layer 122a, the second passivation contact layer 123b, the recombination layer 130b and the transparent electrode layer 114b in the tandem solar cell 100f.

Exemplarily, when the tandem solar cell includes the first passivation contact layer, the doped layer, the recombination layer and the transparent electrode layer, at least one of the first passivation contact layer, the doped layer, the recombination layer or the transparent electrode layer may be improved to reduce parasitic absorption. That is, only the first passivation contact layer may be improved, or the first passivation contact layer and the doped layer may be improved, or the first passivation contact layer, the doped layer and the recombination layer may be improved, or the first passivation contact layer, the doped layer, the recombination layer and the transparent electrode layer may be improved, and so on, which is not specifically limited herein. Exemplarily, FIG. 14 illustrates the case where the first passivation contact layer 122a, the recombination layer 130b and the doped layer 124a in the tandem solar cell 100e are improved.

For the improvements to the first passivation contact layer, the second passivation contact layer, the doped layer and the recombination layer, a passivation layer may be arranged on the improved layer structures, or no passivation layer is arranged correspondingly. Some of the above embodiments illustrate the cases where the first passivation layer 140, the second passivation layer 150, the third passivation layer 160b and the fourth passivation layer 170 are arranged.

FIG. 18 is a schematic sectional view of a tandem solar cell 100g in some other embodiments of the present invention. Exemplarily, referring to FIG. 18, the first passivation contact layer 122a, the second passivation contact layer 123b, the recombination layer 130 b and the transparent electrode layer 114b are all improved. The first passivation layer 140 is arranged on the first passivation contact layer 122a correspondingly, the second passivation layer 150 is arranged on the recombination layer 130b correspondingly, and the third passivation layer 160b is arranged on the second passivation contact layer 123b correspondingly.

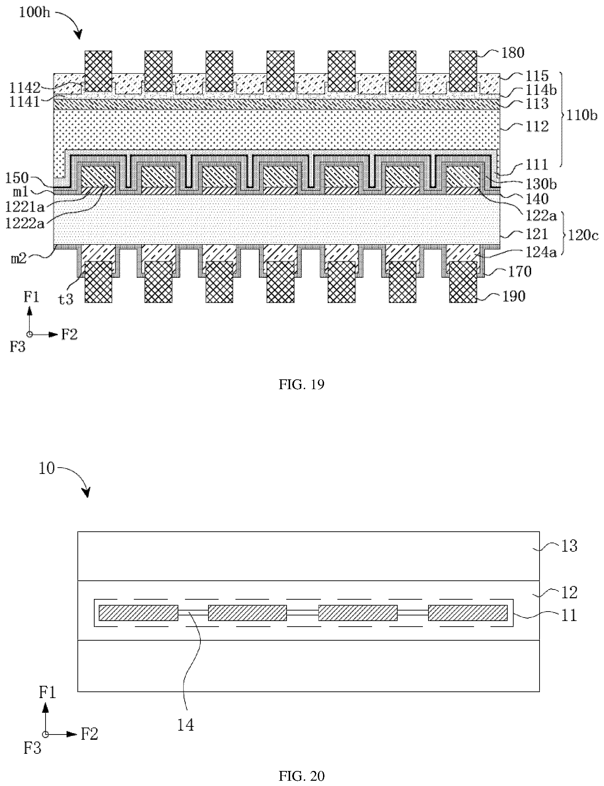

FIG. 19 is a schematic sectional view of a tandem solar cell 100h in some other embodiments of the present invention. Exemplarily, referring to FIG. 19, the first passivation contact layer 122a, the doped layer 124a, the recombination layer 130b and the transparent electrode layer 114b are all improved. The first passivation layer 140 is arranged on the first passivation contact layer 122a correspondingly, the second passivation layer 150 is arranged on the recombination layer 130b correspondingly, and the fourth passivation layer 170 is arranged on the doped layer 124a correspondingly.

In some of the above embodiments, the improvement to each layer structure and the arrangement of the passivation layer may be combined, which is not specifically limited herein.

Each film layer in the tandem solar cell in the related art is a full-surface film layer, which is beneficial to extraction and transmission of charges, but too many film layers will inevitably lead to an increase in unusable light and an increase of parasitic absorption, thus resulting in a large light loss of the tandem solar cell in the full spectrum to cause a large impact on the short-circuit current, and thus making it difficult to improve the efficiency of the tandem solar cell. In addition, since most of the film layers in the tandem solar cell are irreplaceable, it is difficult to improve the efficiency of the tandem solar cell by reducing the number of film layers.

With reference to the cases illustrated in some of the above embodiments, in the embodiments of the present invention, the relevant layer structures in the tandem solar cell are improved, thereby reducing parasitic absorption, increasing short-circuit current, and improving efficiency. After improvements, not only can the optical losses of the entire tandem solar cell be reduced, light responses of different wavelengths can be improved, and the short-circuit current of the cell can be increased, but also the physical contact area and electrical connection efficiency of the interface can be increased, the resistance between the interfaces can be reduced, and the transport and collection of minority carriers in the cell can be improved, thereby increasing the fill factor of the cell. What's more, the recombination defects at the interface are reduced through the relevant passivation layers, so that a certain open-circuit voltage and a certain fill factor can be achieved.

In particular, when forming the structure shown in FIG. 18 and FIG. 19, a structure having an improved layer structure and a passivation layer alternately arranged, namely a structure, in which the first passivation contact layer 122a, the first passivation layer 140, the recombination layer 130b and the second passivation layer 150 are stacked, is formed. In addition, an improved layer structure and a passivation layer are also arranged at the side of the substrate 121 facing away from the top cell unit 110b. The alternating structure and most of the improved layers cooperating with passivation layers can not only further reduce optical losses and increase short-circuit current, but also reduce defects and recombination centers through the passivation layer, and reduce the potential energy barrier of the film layers, so that minority carriers are quickly transmitted, thereby increasing the open-circuit voltage and the fill factor of the tandem solar cell. Therefore, in such a case, the film layers cooperate with each other, which can increase the short-circuit current while having a certain open-circuit voltage and a certain fill factor, thereby further improving the efficiency of the cell.

An exemplary description of the tandem solar cell in the embodiments of the present invention is provided hereinafter in combination with the contents illustrated in some of the above embodiments, but the invention is not limited thereto.

Exemplarily, referring to FIG. 18, a method for manufacturing the tandem solar cell 100g includes the following steps S1 to S18.

At Step S1, a substrate 121 is provided. The substrate 121 is an N-type single crystal silicon wafer.

At Step S2, an initial second tunneling layer is formed on a second surface m2 of the substrate 121 by using an LPCVD process.

At Step S3, an amorphous silicon layer is deposited on the surface of the initial second tunneling layer facing away from the substrate 121 in a high-temperature diffusion furnace, and then boron diffusion and oxidation annealing are performed to form a P-type polysilicon layer. The P-type polysilicon layer is an initial second doped conductive layer.

At Step S4, the initial second tunneling layer and the initial second doped conductive layer are processed by a laser etching process to form a second tunneling layer 1231b and a second doped conductive layer 1232b. The second tunneling layer 1231b and the second doped conductive layer 1232b constitute a second passivation contact layer 123b.

At Step S5, the second passivation contact layer 123b is passivated in a high temperature diffusion furnace to form a third passivation layer 160b.

At Step S6, an electrode is printed by a screen-printing process at a position corresponding to the second passivation contact layer 123b, and then high-temperature sintering and annealing treatment at a temperature of 600°C to 900°C are performed to form a second electrode 190 which is in ohmic contact with the second doped conductive layer 1232b.

At Step S7, an initial first tunneling layer is formed on a first surface m1 of the substrate 121 by using the LPCVD process.

At Step S8, an amorphous silicon layer is deposited on the surface of the initial first tunneling layer facing away from the substrate 121 in the high-temperature diffusion furnace, and then phosphorus diffusion and oxidation annealing are performed to form an N-type polysilicon layer. The N-type polysilicon layer is the initial first doped conductive layer.

At Step S9, the initial first tunneling layer and the initial first doped conductive layer are processed by a laser etching process to form a first tunneling layer 1221a and a first doped conductive layer 1222a. The first tunneling layer 1221a and the first doped conductive layer 1222a constitute a first passivation contact layer 122a.

At Step S10, the first passivation contact layer 122a is passivated in the high temperature diffusion furnace to form the first passivation layer 140.

At Step S11, ITO is sputtered on the surface by a PVD process at a temperature of 300°C to 500°C to form an initial recombination layer.

At Step S12, a thinning treatment is performed on a portion of the initial recombination layer corresponding to a portion of the substrate 121 not covered by the first passivation contact layer 122a by a laser etching process to form a recombination layer 130b, and a second passivation layer 150 is formed on a surface of the recombination layer 130b facing away from the substrate 121.

At Step S13, a certain amount of hole transport material is weighed and obtained, and completely dissolved in 2 mL of a mixed solution of anhydrous ethanol and DMSO, and an appropriate amount of the solution is taken out and dropped onto the surface of the second passivation layer 150 facing away from the recombination layer 130b, a spin coating at 3000 rpm is performed for 25 to 30 seconds, and then an annealing treatment at a temperature of 90°C to 110°C is performed for 10 minutes to form a first charge transport layer 111.

At Step S14, a perovskite layer is formed on a surface of the first charge transport layer 111 facing away from the second passivation layer 150, and the perovskite layer serves as the light absorption layer 112.

At Step S15, a second charge transport layer 113 made of C60 is formed by evaporation on a surface of the light absorption layer 112 facing away from the first charge transport layer 111.

At Step S16, an initial transparent electrode layer made of IZO is formed by a magnetron sputtering process on a surface of the second charge transport layer 113 facing away from the light absorption layer 112.

At Step S17, the initial transparent electrode layer is processed by a laser etching process to form a transparent electrode layer 114b including a first sublayer 1141 and a second sublayer 1142. The second sublayer 1142 is arranged corresponding to the first passivation contact layer 122a.

At Step S18, a first electrode 180 made of silver is formed by evaporation at a position corresponding to the second sublayer 1142 of the transparent electrode layer 114b.

During the manufacture illustrated above, a protective layer 115 made of MgF₂ may also be formed by vapor deposition on the transparent electrode layer 114b and on the first electrode 180. The manufacturing process of the tandem solar cell 100h illustrated in FIG. 19 differs from the manufacturing process illustrated above in that: a diffusion processing is performed on the second surface m2 of the substrate 121 in a diffusion furnace containing a P-type dopant to form an initial doped diffusion layer, and then a doped diffusion layer is formed by a laser etching process, and then the fourth passivation layer 170 is formed. When forming the layer structure to be improved as mentioned above, a mask process may also be used for manufacturing, which is not specifically limited herein. It should be noted that the steps in the manufacturing method illustrated above do not have to be performed in the order of the steps illustrated above. For example, if it may be realized and easy to operate, the first passivation contact layer may also be manufactured first, and then the second passivation contact layer is manufactured. No specific restrictions are made herein.

The tandem solar cells in the embodiments of the present invention are exemplarily described below in combination with the structures of the tandem solar cells illustrated in some of the embodiments above and related comparative examples.

In Example 1, the structure of the tandem solar cell 100a shown in FIG. 1 is adopted. The substrate 121 is an N-type single crystal silicon substrate with a thickness of 180 µm. The first tunneling layer 1221a is made of silicon oxide with a thickness of 1.5 nm. The first doped conductive layer 1222a is a phosphorus-doped polysilicon layer with a thickness of 200 nm. The first passivation layer 140 is made of aluminum oxide with a thickness of 2 nm. The second tunneling layer 1231a is made of silicon oxide with a thickness of 2 nm. The second doped conductive layer 1232a is a boron-doped polysilicon layer with a thickness of 250 nm. The third passivation layer 160a is made of silicon nitride with a thickness of 100 nm. The recombination layer 130a is made of ITO with a thickness of 30 nm. The first charge transport layer 111 is made of doped NiO with a thickness of 10 nm. The light absorption layer 112 is made of perovskite with a thickness of 900 nm. The material of the second charge transport layer 113 is C60, and the thickness thereof is 20 nm. The material of the transparent electrode layer 114a is IZO, and the thickness thereof is 80 nm. The material of the protective layer 115 is magnesium fluoride, and the thickness thereof is 90 nm. The material of the first electrode 180 is silver, the first electrode 180 has two main grid lines and six secondary grid lines, the width of the main grid line is 150 µm, and the width of the secondary grid line is 80 µm. The material of the second electrode 190 is silver paste, the second electrode 190 has three main grid lines and ten secondary grid lines, the width of the main grid line is 200 µm, and the width of the secondary grid line is 100 µm.

Example 2 differs from Example 1 in that: the first passivation contact layer 122b shown in FIG. 4 is adopted, and the area of the first passivation contact layer 122b accounts for 45% of the area of the first surface m1 of the substrate 121.

Example 3 differs from Example 1 in that: the first passivation contact layer 122c shown in FIG. 5 is adopted, and the total area of the first through holes k1 accounts for 55% of the area of the first surface m1 of the substrate 121.

Example 4 differs from Example 1 in that: the first passivation contact layer 122d shown in FIG. 6 is adopted, and the area of the first passivation contact layer 122d accounts for 30% of the area of the first surface m1 of the substrate 121.

Example 5 differs from Example 1 in that: the structure of the tandem solar cell 100b shown in FIG. 7 is adopted, the thickness of the first portion 131 of the recombination layer 130b is 30 nm, and the thickness of the portion of the second portion 132 not in contact with the first passivation contact layer 122a is 5 nm.

Example 6 differs from Example 5 in that: the structure of the tandem solar cell 100c shown in FIG. 9 is adopted, and the second passivation layer 150 is arranged; and the material of the second passivation layer 150 is 2PACz, and the thickness thereof is 3 nm.

Example 7 differs from Example 5 in that: the structure of the tandem solar cell 100d shown in FIG. 11 is adopted; the material of the second tunneling layer 1231b is silicon oxide, and the thickness thereof is 2 nm; the second doped conductive layer 1232b is a boron-doped polysilicon layer with a thickness of 250 nm; and the material of the third passivation layer 160b is silicon nitride, and the thickness thereof is 100 nm.

Example 8 differs from Example 6 in that: the second passivation contact layer in Example 7 is adopted, that is, the material of the second tunneling layer 1231b is silicon oxide, and the thickness thereof is 2 nm; the second doped conductive layer 1232b is a boron-doped polysilicon layer with a thickness of 250 nm; and the material of the third passivation layer 160b is silicon nitride, and the thickness thereof is 100 nm.

Example 9 differs from Example 1 in that: the structure of the tandem solar cell 100e shown in FIG. 14 is adopted, and the second passivation contact layer is not arranged, but the doped layer 124a is arranged; the doped layer 124a is a boron diffusion layer with a thickness of 500 nm; the material of the fourth passivation layer is silicon nitride, and the thickness thereof is 90 nm; and the thickness of the first portion 131 of the recombination layer 130b is 30 nm, and the thickness of the portion of the second portion 132 not in contact with the first passivation contact layer 122a is 5 nm.

Example 10 differs from Example 9 in that: the structure of the tandem solar cell 100h shown in FIG. 19 is adopted, and the second passivation layer 150 is arranged; and the material of the second passivation layer 150 is 2PACz, and the thickness thereof is 3 nm.

Example 11 differs from Example 7 in that: the structure of the tandem solar cell 100f shown in FIG. 17 is adopted, the material of the transparent electrode layer 114b is IZO, the thickness of the first sublayer 1141 is 20 nm, and the thickness of the second sublayer 1142 is 80 nm.

Example 12 differs from Example 11 in that: the structure of the tandem solar cell 100g shown in FIG. 18 is adopted; and the second passivation layer 150 is arranged, the material of the second passivation layer 150 is 2PACz, and the thickness thereof is 3 nm.

Comparative Example 1 differs from Example 1 in that: the first tunneling layer and the first doped conductive layer each are arranged in a whole layer; the first tunneling layer is made of silicon oxide with a thickness of 1.5 nm; and the first doped conductive layer is a phosphorus-doped polysilicon layer with a thickness of 200 nm.

Comparative Example 2 differs from Example 9 in that: the doped layer is arranged in a whole layer, and the first tunneling layer, the first doped conductive layer and the recombination layer each are arranged in a whole layer; the doped layer is a boron diffusion layer with a thickness of 500 nm; the first tunneling layer is made of silicon oxide with a thickness of 1.5 nm; the first doped conductive layer is a phosphorus-doped polysilicon layer with a thickness of 200 nm; and the recombination layer is made of ITO with a thickness of 30 nm.

Comparative Example 3 differs from Example 1 in that the first passivation layer is not arranged.

Examples 1 to 12 and Comparative Examples 1 to 3 were tested under AM1.5G simulated sunlight and at 25 degrees Celsius by using a solar simulator. The test results are shown in Table 1. The effective area of the tandem solar cell is 1 cm².

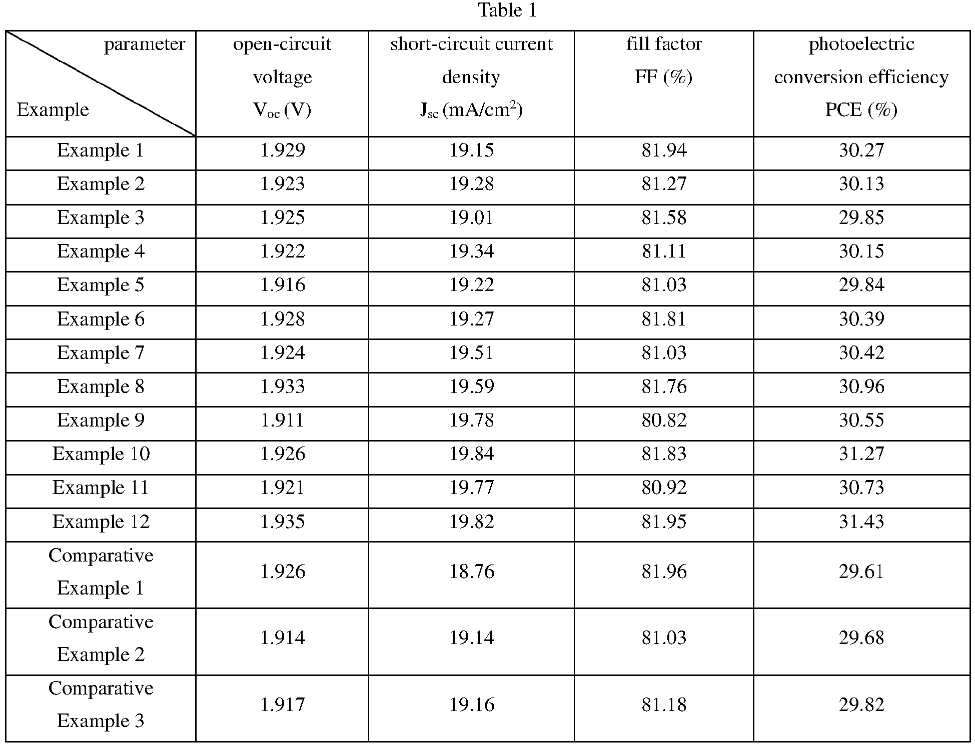

As can be seen from Table 1, compared with Comparative Examples 1 to 3, overall, the conversion efficiency of Examples 1 to 12 is higher.

Compared with Comparative Examples 1 to 3, the first doped conductive layer in Example 1 is patterned in strips, which not only reduces the parasitic absorption of the first doped conductive layer, allows the crystalline silicon layer to receive more light sources, and increases the short-circuit current of the cell, but also adds an aluminum oxide passivation layer to reduce defects in the first doped conductive layer and the patterned area, reduces recombination centers, and prevents decrease of the open-circuit voltage and the fill factor, thereby improving the efficiency of the tandem cell as a whole.

In Example 2, the patterning shape of the first doped conductive layer is transformed from a strip into multiple separate portions, so that: the reserved area of the first doped conductive layer is smaller, more incident light is effectively utilized, and the short-circuit current is further improved. However, the first doped conductive layer is in an arrangement of islands which are less interconnected and more damaged. After passivation, there is a slight decrease in the open-circuit voltage and the fill factor. Although the final efficiency improvement of the tandem cell is not as good as that of Example 1, it is still higher than that of Comparative Example 1 and still has certain advantages.

In Example 3, part of the first doped conductive layer is cut out to form a hollow structure, and most of the first doped conductive layer structure may be retained. Although the short-circuit current is less increased, on the whole, the first doped conductive layer is less damaged, normal open-circuit voltage and fill factor can be achieved after passivation, and the efficiency of the tandem cell can still be improved.

In Example 4, the first doped conductive layer is substantially arranged to be in a mesh shape, which increases more short-circuit current while ensuring that the remaining parts of the first doped conductive layer are connected to each other, so that: carriers can be transported faster, the open-circuit voltage and the fill factor decrease less after passivation, the combined current is greatly increased, and the overall stacking efficiency is greatly improved.

In Example 5, the recombination layer is further patterned on the basis of Example 1. Due to the damage of the recombination layer, the charge transport is greatly affected, so the open-circuit voltage and the fill factor are reduced, and the advantage of the improvement of the cell efficiency is relatively small, but the cell efficiency is still improved overall.

In Example 6, based on Example 5, the recombination layer is passivated to reduce defects and recombination centers in the recombination layer, reduce the probability of carrier capture, and improve the energy level matching between the first doped conductive layer and the first charge transport layer, which can greatly increase the open-circuit voltage and the fill factor, and further improve the stacking efficiency.

In Example 7, the first doped conductive layer is patterned to reduce the parasitic absorption of long-wavelength light by the bottom cell unit. More long-wavelength light is absorbed by the crystalline silicon layer to generate more photogenerated carriers, thereby further improving the short-circuit current of the tandem cell. In addition, the patterning of the first doped conductive layer will be coordinated with the passivation treatment, and the passivation effect of the etched portion is better than that of the first doped conductive layer. Therefore, the open-circuit voltage will be increased. Combined with the increase of the short-circuit current, the cell efficiency can be further improved.

In Example 8, the recombination layer is passivated based on Example 7, the open-circuit voltage and the fill factor are increased, and the cell efficiency is improved.

In Example 9, the second doped conductive layer is replaced by the boron diffusion layer, and the passivation effect of the second passivation contact layer is lost, so the open-circuit voltage is decreased. However, since there is no obvious parasitic absorption of the second doped conductive layer, the short-circuit current of the cell is increased again. Due to the damage of the recombination layer, the fill factor is relatively low and the cell efficiency changes little.

In Example 10, the recombination layer is passivated based on Example 9, the open-circuit voltage and the fill factor are increased, and the cell efficiency is improved.

In Example 11, the transparent electrode layer is patterned, which not only reduces the reflection of incident light, but also reduces the parasitic absorption of the transparent electrode layer itself, allowing more light to reach other functional layers to generate more photogenerated carriers, thereby increasing the short-circuit current and further improving the overall efficiency of the cell.

In Example 12, the recombination layer is passivated based on Example 11, defects are reduced, charge transport is smoother, the open-circuit voltage and the fill factor are increased, and the cell efficiency is further improved.

In particular, in Example 10 and Example 12, due to the synergistic effect of the overall patterning, the optical loss can be reduced and the contact area can be increased, the light response to each band can be improved and the contact resistance can be reduced, the functional layer can generate more photogenerated carriers, thus the short-circuit current can be greatly improved. The arrangement of the passivation layer can reduce interface composite defects and enhance the transport and collection of minority carriers in the cell, so that the open-circuit voltage and the fill factor may not decrease, while the cell efficiency is greatly improved.

As can be seen from above results, the tandem solar cell provided in the embodiments of the present invention has more advantages.

It should be noted that the aforementioned patterning process refers to a process in which a corresponding layer is partially removed based on the arrangement of the entire layer. The patterning process may be performed by using the laser etching process illustrated in some of the aforementioned embodiments, and will not be described in detail herein.

FIG. 20 is a schematic view showing a structure of a photovoltaic module 10 in some embodiments of the present invention. According to some embodiments of the present invention, referring to FIG. 20, the embodiments of the present invention provide a photovoltaic module 10, including a cell string 11, an encapsulation layer 12 and a cover plate 13. The encapsulation layer 12 is configured to cover the surface of the cell string 11. The cover plate 13 is configured to cover the surface of the encapsulation layer 12 facing away from the cell string 11. The cell string 11 is formed by connecting a plurality of tandem solar cells of any of the above embodiments.

In some embodiments, multiple cell strings 11 may be electrically connected via a conducting strip 14. The encapsulation layer 12 is adapted to cover the front and back sides of the tandem solar cell.

In some embodiments, the encapsulation layer 12 may be an organic encapsulation adhesive film such as an ethylene-vinyl acetate copolymer (EVA) adhesive film, an ethylene-octene copolymer elastomer (or POE) adhesive film, or a polyethylene terephthalate (PET) adhesive film.

In some embodiments, the cover plate 13 may be a glass cover plate, a plastic cover plate or other cover plate having a light-transmitting function.

In some embodiments, the surface of the cover plate 13 facing the encapsulation layer 12 may be a concave-convex surface, thereby increasing the utilization rate of incident light.

The photovoltaic module 10 also has the advantages of any one of the tandem solar cells above, which will not be described in detail herein.

## Claims

1. A tandem solar cell (100a to 100h), **characterized by** comprising a top cell unit (110a, 110b) and a bottom cell unit (120a to 120c) stacked along a first direction (F1), and a recombination layer (130a, 130b) disposed between the top cell unit (110a, 110b) and the bottom cell unit (120a to 120c); wherein orthographic projections of the top cell unit (110a, 110b) and the bottom cell unit (120a to 120c) on a reference plane (E) coincide with each other to form an overlapping projection (y2), and the reference plane (E) is a plane perpendicular to the first direction (F1);
the bottom cell unit (120a to 120c) comprises a substrate (121) and a first passivation contact layer (122a to 122d), wherein the first passivation contact layer (122a to 122d) comprises a first tunneling layer (1221a) and a first doped conductive layer (1222a) stacked and disposed on a surface (m1) of the substrate (121) facing the top cell unit (110a, 110b); an orthographic projection (y1) of the first passivation contact layer (122a to 122d) on the reference plane (E) is within a range of the overlapping projection (y2), and an area of the orthographic projection (y1) of the first passivation contact layer (122a to 122d) on the reference plane (E) is smaller than an area of the overlapping projection (y2);
a portion of the surface (m1) of the substrate (121) facing the top cell unit (110a, 110b) exposed by the first passivation contact layer (122a to 122d) is a first sub-surface (m11); the first passivation contact layer (122a to 122d) has a first target surface (t1) not in contact with the surface (m1) of the substrate (121) facing the top cell unit (110a, 110b) and located in the tandem solar cell (100a to 100h);
the tandem solar cell (100a to 100h) further comprises a first passivation layer (140), wherein the first passivation layer (140) is disposed on the first sub- surface (m11) and the first target surface (t1); and surfaces of the recombination layer (130a, 130b) and the first passivation layer (140) facing each other are in contact with each other.

2. The tandem solar cell (100a to 100h) according to claim **1,** wherein the first passivation contact layer (122a to 122d) comprises a plurality of first passivation contact portions (1220a, 1220b) arranged at intervals;
wherein, preferably, at least part of the plurality of first passivation contact portions (1220a, 1220b) are arranged at intervals along a second direction (F2), and at least one of the plurality of first passivation contact portions (1220a) is arranged to extend longitudinally along a third direction (F3) or at least two of the plurality of first passivation contact portions (1220b) are arranged at intervals along the third direction (F3); and
the second direction (F2) and the third direction (F3) intersect each other and are perpendicular to the first direction (F1).

3. The tandem solar cell (100a to 100h) according to claim **1,** wherein
a plurality of first through holes (k1) are formed in the first passivation contact layer (122c) and penetrate the first passivation contact layer (122c) along the first direction (F1); or
the first passivation contact layer (122d) comprises a plurality of first sub-portions (12201) and a plurality of second sub-portions (12202); the plurality of first sub-portions (12201) are extended along a fourth direction (F4) and arranged at intervals along a fifth direction (F5); the plurality of second sub-portions (12202) are arranged at intervals along the fourth direction (F4); at least one of the plurality of second sub-portions (12202) is connected to at least one of the plurality of first sub-portions (12201); and the fourth direction (F4) and the fifth direction (F5) intersect each other and are perpendicular to the first direction (F1).

4. The tandem solar cell (100a to 100h) according to any one of claims 1 to 3, wherein
a material of the first passivation layer (140) comprises metal oxide, non-metal nitrides or non-metal nitrogen oxides; or
a material of the first passivation layer (140) comprises metal oxide, and a thickness (h1) of the first passivation layer (140) is in a range from 1 nm to 50 nm; or
a material of the first passivation layer (140) comprises non-metal nitrides or non-metal nitrogen oxides, and a thickness (h1) of the first passivation layer (140) is in a range from 50 nm to 100 nm.

5. The tandem solar cell (100a to 100h) according to any one of claims 1 to 3, wherein the recombination layer (130a, 130b) comprises a first portion (131) and a second portion (132);
an orthographic projection of the first portion (131) on the reference plane (E) and the orthographic projection (y1) of the first passivation contact layer (122a to 122d) on the reference plane (E) coincide each other; a thickness (d2) of a portion of the second portion (132) not in contact with the first passivation contact layer (122a to 122d) is smaller than a thickness (d1) of the first portion (131).

6. The tandem solar cell (100a to 100h) according to claim 5, further comprising a second passivation layer (150), wherein the second passivation layer (150) is disposed on a surface of the recombination layer (130a, 130b) facing away from the bottom cell unit (120a to 120c).

7. The tandem solar cell (100a to 100h) according to claim 6, wherein the second passivation layer (150) is configured as a monomolecular layer; or a thickness (h2) of the second passivation layer (150) is in a range from 0.3 nm to 2 nm.

8. The tandem solar cell (100a to 100h) according to any one of claims 1 to 3, wherein the bottom cell unit (120a to 120c) further comprises a second passivation contact layer (123a to 123c), wherein the second passivation contact layer (123a to 123c) comprises a second tunneling layer (1231a, 1231b) and a second doped conductive layer (1232a, 1232b) stacked on a surface (m2) of the substrate (121) facing away from the top cell unit (110a, 110b); and
an orthographic projection of the second passivation contact layer (123a to 123c) on the reference plane (E) is located within the range of the overlapping projection (y2), and an area of the orthographic projection of the second passivation contact layer (123a to 123c) on the reference plane (E) is smaller than the area of the overlapping projection (y2).

9. The tandem solar cell (100d, 100f, 100g) according to claim 8, wherein
the second passivation contact layer (123b) comprises a plurality of second passivation contact portions (1230) arranged at intervals; or
a plurality of second through holes (k2) are formed in the second passivation contact layer (123c) and penetrate the second passivation contact layer (123c) along the first direction (F1).

10. The tandem solar cell (100d, 100f, 100g) according to claim 8, wherein a portion of a surface (m2) of the substrate (121) facing away from the top cell unit (110a, 110b), exposed by the second passivation contact layer (123b), is a second sub-surface (m21); the second passivation contact layer (123b) has a second target surface (t2) not in contact with the surface (m2) of the substrate (121) facing away from the top cell unit (110a, 110b) and located in the tandem solar cell (100d, 100f, 100g); and
the tandem solar cell (100d, 100f, 100g) further comprises a third passivation layer (160b), and the third passivation layer (160b) is disposed on the second sub-surface (m21) and the second target surface (t2);
wherein, preferably, a material of the third passivation layer (160b) comprises metal oxide, non-metal nitrides or non-metal nitrogen oxides; and
wherein, preferably, a material of the third passivation layer (160b) comprises metal oxide, and a thickness (h3) of the third passivation layer (160b) is in a range from 1 nm to 50 nm; or
a material of the third passivation layer (160b) comprises non-metal nitrides or non-metal nitrogen oxides, and a thickness (h3) of the third passivation layer (160b) is in a range from 50 nm to 100 nm.

11. The tandem solar cell (100e, 100h) according to any one of claims 1 to 3, wherein the bottom cell unit (120a to 120c) further comprises a doped layer (124a, 124b) disposed on a surface (m2) of the substrate (121) facing away from the top cell unit (110a, 110b);
an orthographic projection of the doped layer (124a, 124b) on the reference plane (E) is within the range of the overlapping projection (y2), and an area of the orthographic projection of the doped layer (124a, 124b) on the reference plane (E) is smaller than the area of the overlapping projection.

12. The tandem solar cell (100e, 100h) according to claim 11, wherein
the doped layer (124a) comprises a plurality of doped portions (1240) disposed at intervals; or
a plurality of third through holes (k3) are formed in the doped layer (124b) and penetrate the doped layer (124b) along the first direction (F1).

13. The tandem solar cell (100e, 100h) according to claim 11, wherein a portion of the surface (m2) of the substrate (121) facing away from the top cell unit (110a, 110b), exposed by the doped layer (124a, 124b), is a third sub-surface (m22); the doped layer (124a, 124b) has a third target surface (t3) not in contact with the surface (m2) of the substrate (121) facing away from the top cell unit (110a, 110b) and located in the tandem solar cell (100e, 100h); and
the tandem solar cell (100e, 100h) further comprises a fourth passivation layer (170), and the fourth passivation layer (170) is disposed on the third sub-surface (m22) and the third target surface (t3);
wherein, preferably, a material of the fourth passivation layer (170) comprises at least one of metal oxide, non-metal nitrides or non-metal nitrogen oxides; and
wherein, preferably a material of the fourth passivation layer (170) comprises metal oxide, and a thickness (h4) of the fourth passivation layer (170) is in a range from 1 nm to 50 nm; or
a material of the fourth passivation layer (170) comprises non-metal nitrides or non-metal nitrogen oxides, and a thickness (h4) of the fourth passivation layer (170) is in a range from 50 nm to 100 nm.

14. The tandem solar cell (100a to 100h) according to any one of claims 1 to 3, wherein the top cell unit (110a, 110b) comprises a first charge transport layer (111), a light absorption layer (112), a second charge transport layer (113) and a transparent electrode layer (114a, 114b) stacked away from the bottom cell unit (120a to 120c);
the transparent electrode layer (114a, 114b) comprises a first sublayer (1141) and a second sublayer (1142), the first sublayer (1141) is arranged on a surface of the second charge transport layer (113) facing away from the light absorption layer (112), and the second sublayer (1142) is arranged on a surface of the first sublayer (1141) facing away from the second charge transport layer (113); and
an orthographic projection of the first sublayer (1141) on the reference plane (E) coincides with the overlapping projection (y2); an orthographic projection of the second sublayer (1142) on the reference plane (E) is located within the range of the overlapping projection (y2); and an area of the orthographic projection of the second sublayer (1142) on the reference plane (E) is smaller than the area of the overlapping projection (y2).

15. A photovoltaic module (10), **characterized by** comprising:
a cell string (11);
an encapsulation layer (12) configured to cover a surface of the cell string (11); and
a cover plate (13) configured to cover a surface of the encapsulation layer (12) away from the cell string (11);
wherein the cell string (11) is formed by connecting a plurality of the tandem solar cells (100a to 100h) according to any one of claims 1 to 14.
